(19) Europäisches Patentamt
European Patent Office
Office européen des brevets

(11) EP 4 571 268 A1

(12) EUROPEAN PATENT APPLICATION
published in accordance with Art. 153(4) EPC

(43) Date of publication:
18.06.2025 Bulletin 2025/25

(51) International Patent Classification (IPC):
G01D 5/245 (2006.01)  G01R 33/02 (2006.01)
G01R 33/09 (2006.01)  H10N 50/10 (2023.01)

(21) Application number: 23852191.8

(22) Date of filing: 10.05.2023

(52) Cooperative Patent Classification (CPC):
G01D 5/245; G01R 33/02; G01R 33/09;
H10N 50/10

(86) International application number:
PCT/JP2023/017513

(87) International publication number:
WO 2024/034206 (15.02.2024 Gazette 2024/07)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 09.08.2022 JP 2022127029

(71) Applicant: National Institute for Materials Science
Tsukuba-shi, Ibaraki 305-0047 (JP)

(72) Inventors:
• NAKATANI, Tomoya
Tsukuba-shi, Ibaraki 305-0047 (JP)
• IWASAKI, Hitoshi
Tsukuba-shi, Ibaraki 305-0047 (JP)

(74) Representative: V.O.
P.O. Box 87930
2508 DH Den Haag (NL)

(54) MAGNETIC JOINT BODY, TMR ELEMENT, TMR ELEMENT ARRAY, MAGNETIC SENSOR, MAGNETIC SENSOR FOR LINEAR ENCODER, AND MAGNETIC ROTARY ENCODER

(57) A magnetic junction includes a first free layer (11), a tunnel barrier layer (12), and a second free layer (13). The tunnel barrier layer (12) is interposed between the first free layer (11) and the second free layer (13). The first and second free layers (11, 13) contain a ferromagnetic metal. A detection-target magnetic field is configured to have a component to be applied in the magnetization hard axis direction of the first and second free layers (11, 13). Magnetizations of the first and second free layers (11, 13) are stabilized in an antiparallel arrangement to each other under no magnetic field, and the magnetizations of the first and second free layers (11, 13) are stabilized in a parallel arrangement to each other in a state in which the strength of an external magnetic field applied in the hard axis direction of the first and second free layers (11, 13) reaches that of the saturation magnetic field.

FIG. 1

EP 4 571 268 A1

## Description

Technical Field

The present disclosure relates to a magnetic junction, a TMR element, a TMR element array, a magnetic sensor, a magnetic sensor for a linear encoder, and a magnetic rotary encoder. Priority is claimed from Japanese Patent Application No. 2022-127029, filed August 9, 2022, the content of which is incorporated herein by reference.

Background Art

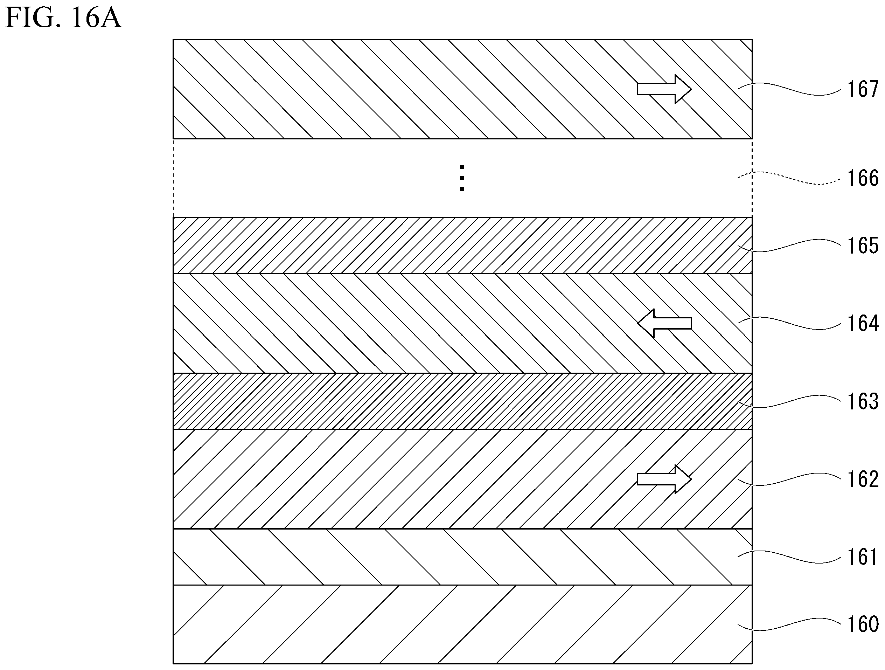

A device for position and rotation detection including a superlattice type giant magnetoresistive element has been proposed (see Patent Document 1). FIG. 16A is an example of the superlattice type giant magnetoresistive element. The superlattice type giant magnetoresistive element shown in FIG. 16A has a stacked structure in which an electrode 160, an under layer 161, a ferromagnetic layer 162, a non-magnetic layer 163, a ferromagnetic layer 164, a non-magnetic layer 165, a repeatedly stacked body 166, and a ferromagnetic layer 167 are stacked in this order. In FIG. 16A, magnetization directions of the ferromagnetic layers 162, 164, and 167 are shown by the arrows. The repeatedly stacked body 166 is obtained by repeatedly stacking a ferromagnetic layer and a non-magnetic layer.

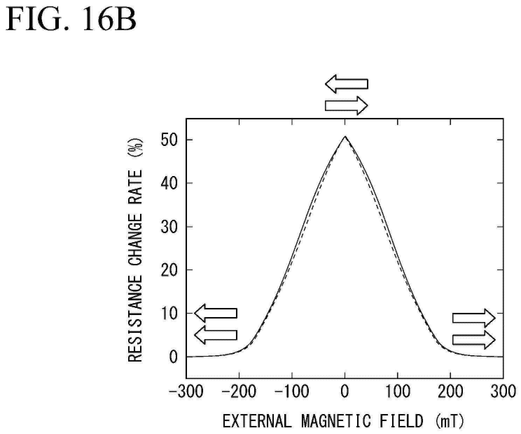

In such a stacked structure body, antiparallel magnetic coupling acting between the ferromagnetic layer 162 and the ferromagnetic layer 164 is utilized, so that the magnetizations of the adjacent ferromagnetic free layers are arranged in an antiparallel manner in a state in which no external magnetic field is applied. In a case where a detection target magnetic field is applied to the superlattice type giant magnetoresistive element, the magnetization of the ferromagnetic free layer rotates, and the resistance of the stacked structure body changes. This phenomenon is exhibited using a giant magnetoresistance (GMR) effect, and a magnetic field is sensed using this effect. As shown in FIG. 16B, the element exhibits a resistance change symmetrical to the positive/negative of a direction in which an external magnetic field applied to the element is applied (hereinafter, referred to as even function resistance magnetic field (R-H) characteristics). Since the element exhibits the above characteristics, it can detect a position and rotation with higher accuracy than a sensor having odd function R-H characteristics to be described later, and is used for an encoder.

However, in a GMR sensor, the resistance change ratio corresponding to an output value of the sensor is as high as about 50%. In order to realize the position and rotation detection with higher accuracy, it is desirable to apply a tunnel magnetoresistance (TMR) sensor exhibiting a resistance change ratio of about 150% to 200%. Here, the resistance change ratio is defined by $(R_{max} - R_{min})/R_{min}$. $R_{max}$ is the maximum resistance value of the GMR or TMR element and $R_{min}$ is the minimum resistance value of the GMR or TMR element. Regarding this, in the TMR sensor, antiparallel magnetic coupling does not act between the two ferromagnetic layers (free layers) through the tunnel barrier layer interposed therebetween. Therefore, in order to arrange the magnetizations of the ferromagnetic layers in an antiparallel manner in the TMR sensor, it is necessary to devise, for example, a soft pin type shown below.

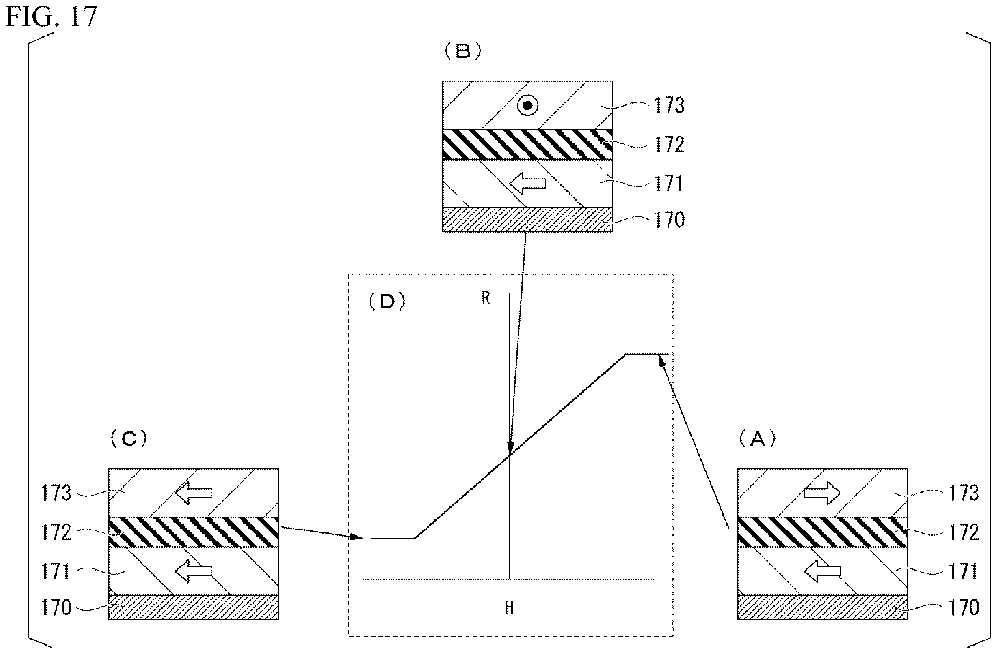

As shown in FIG. 17, a normal spin valve type TMR sensor, that is put into practical use for a magnetic head or the like, has a multilayer structure including an antiferromagnetic layer 170, a pinned layer 171, a tunnel barrier layer 172, and a first free layer 173. (A) of FIG. 17 is a diagram showing the magnetization directions of the pinned layer 171 and the first free layer 173 in a state in which the external magnetic field is saturated in a positive direction. (B) of FIG. 17 is a diagram showing the magnetization directions of the pinned layer 171 and the first free layer 173 in a state of zero external magnetic field. (C) of FIG. 17 is a diagram showing the magnetization directions of the pinned layer 171 and the first free layer 173 in a state in which the external magnetic field is saturated in a negative direction.

The magnetization of the pinned layer 171 is fixed by exchange bias with the adjacent antiferromagnetic layer 170. The magnetization of the first free layer 173 is stabilized in a direction orthogonal to the magnetization of the pinned layer 171 in a state in which no external magnetic field is applied (see Non Patent Documents 1 and 2). The direction of the magnetization of the first free layer 173 can be determined by a bias magnetic field generated by a permanent magnet or induced magnetic anisotropy due to a heat treatment in the magnetic field. However, in the spin valve type TMR sensor, in a case where an element resistance increases under a positive magnetic field, the element resistance decreases under a negative magnetic field and R-H characteristics close to linear response are exhibited. In a case where the element resistance decreases under a positive magnetic field, R-H characteristics close to linear response in which the element resistance increases under a negative magnetic field are exhibited. In a case where the linear responsiveness deteriorates, there is a problem that the sensor's position detection accuracy deteriorates.

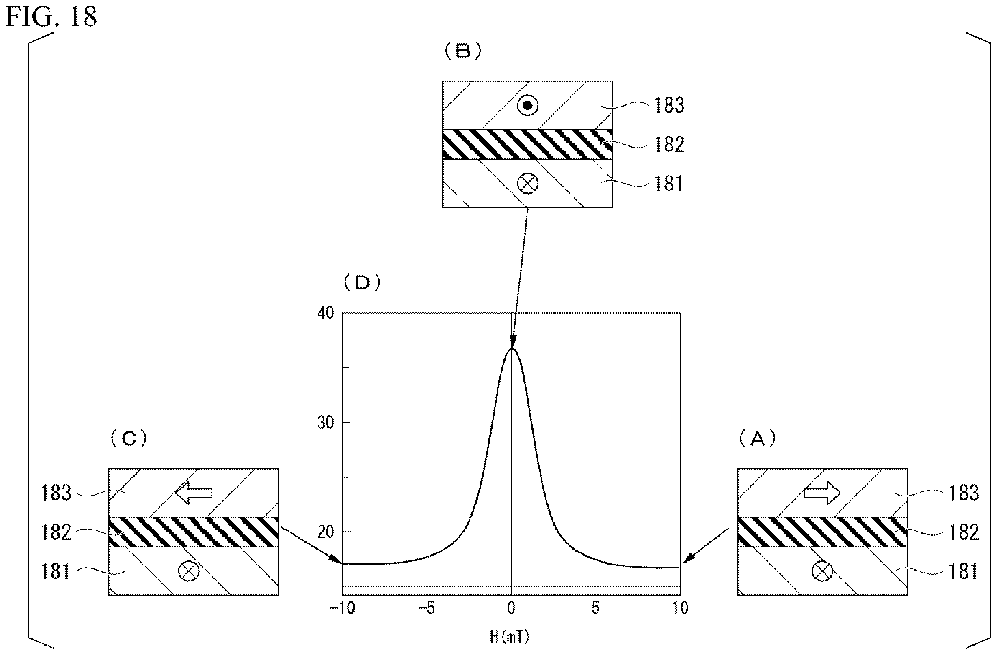

In addition, FIG. 18 is a diagram showing an example of a single soft pin type TMR sensor (see Non Patent Documents 3 and 4). The single soft pin type TMR sensor has a layer structure in which a pinned layer 181, a tunnel barrier layer 182, and a free layer 183 are stacked. (A) of FIG. 18 is a diagram showing the magnetization directions of the pinned layer 181 and the free layer 183 in a state in which a sufficiently large external magnetic field relative to the anisotropic magnetic field of the free layer 183 is applied in a positive direction and the magnetization of the free layer 183 is saturated in the positive direction. (B) of FIG. 18 is a diagram showing the magnetization directions of the pinned layer 181 and the free layer 183 in a state of zero external magnetic field. (C) of FIG. 18 is a diagram showing the magnetization directions of the pinned layer 181 and the free layer 183 in a state in which the magnetization of the free layer 183 is saturated in a negative direction.

In the single soft pin type TMR sensor, the magnetization of the free layer 183 is stabilized (softly pinned) in a direction opposite to the magnetization of the pinned layer 181, and even function R-H characteristics are exhibited. However, since $R_{min}$ of the element is the resistance in a state in which the magnetization of the free layer 183 and the magnetization of the pinned layer 181 are arranged orthogonal to each other, the element exhibits a smaller resistance change ratio of about 110% than the spin valve type. In the single soft pin type TMR sensor, in a case where a direction of a detection-target magnetic field deviates from a magnetization hard axis direction of the free layer that is an original direction, the element's even function R-H characteristics, that are originally strictly symmetrical to the positive/negative of the magnetic field to be detected, become asymmetrical. Therefore, the sensor has a problem that high positioning accuracy is required when the sensor is mounted.

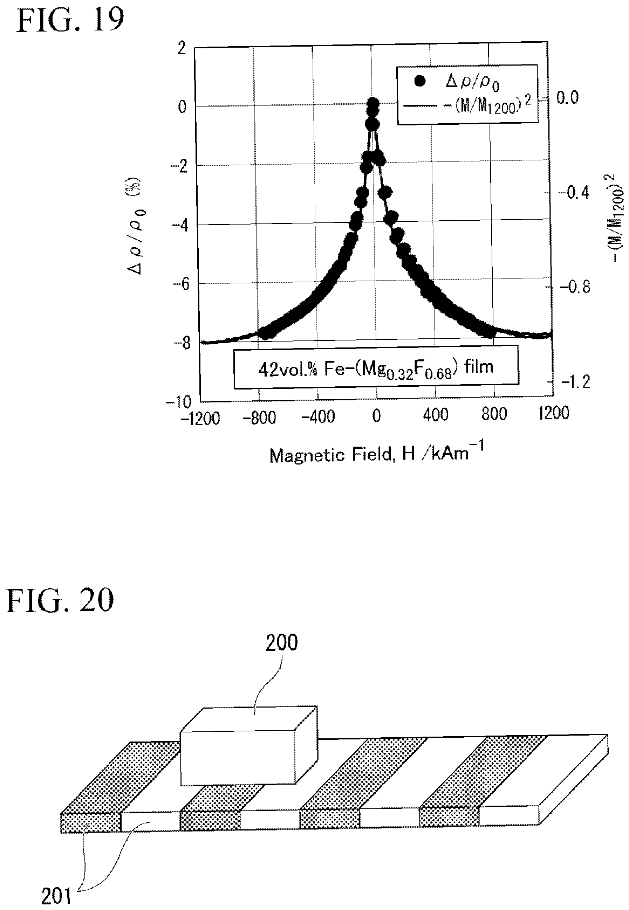

FIG. 19 is a diagram showing the magnetoresistance characteristics of a granular TMR element in which ferromagnetic nanoparticles are dispersed in an insulating matrix. The granular TMR element can obtain even function R-H characteristics that are strictly symmetrical to the positive/negative of a magnetic field to be detected applied to the element. However, the granular TMR element is not suitable for a magnetic sensor having high sensitivity since it exhibits a small resistance change ratio of about 10% (see Non Patent Document 5).

Citation List

Patent Documents

Patent Document 1: Japanese Unexamined Patent Application, First Publication No. 2021-71334

Patent Document 2: US 2017/0154643 A1

Non Patent Documents

Non Patent Document 1: Journal of Applied Physics 92, 4722 (2002)
Non Patent Document 2: J. Appl. Phys. 111, 07C710 (2012)
Non Patent Document 3: The 45th Annual Conference of the Magnetics Society of Japan, 01aB-11
Non Patent Document 4: Journal of the Japan Institute of Metals and Materials, Vol. 75 (2011), 419-423
Non Patent Document 5: Journal of the Japan Institute of Metals and Materials, Vol. 76 (2012), 375-379

Summary of Invention

Technical Problem

The drawbacks and problems of the related art will be summarized as follows.

A superlattice type GMR element has a problem in realizing high sensitivity since the resistance change ratio is at most as small as 50%.

A spin valve type TMR element has a problem in realizing high-accuracy linear responsiveness in position detection with high accuracy, due to odd function R-H characteristics.

In a single soft pin type TMR element, the resistance change ratio is about 110%, that is smaller than that of the spin valve type (about 150% to 200%). Furthermore, in the single soft pin type TMR element, in a case where a direction of a magnetic field to be detected deviates, the R-H characteristics become asymmetrical, and the position detection accuracy deteriorates.

A granular TMR element exhibits a resistance change ratio of about 10%.

The present disclosure is contrived in view of the above-described problems, and an object thereof is to provide a magnetic junction, a TMR element, a magnetic sensor, a TMR element array, a magnetic sensor, a magnetic sensor for a linear encoder, and a magnetic rotary encoder, in which the resistance change ratio is large and R-H characteristics are less likely to be asymmetrical due to a deviation of a direction of a magnetic field to be detected.

Solution to Problem

[1] A magnetic junction according to a first aspect includes: a first free layer 11 having a magnetization easy axis and a magnetization hard axis orthogonal to the magnetization easy axis; a tunnel barrier layer 12; and a second free layer 13 having a magnetization easy axis and a magnetization hard axis orthogonal to the magnetization easy axis. The tunnel barrier layer 12 is interposed between the first free layer 11 and the second free layer 13. The first free layer 11 and the second free layer 13 contain a ferromagnetic metal. A detection-target magnetic field is configured to have a component to be applied in the magnetization hard axis direction of the first free layer and the second free layer. The magnetization of the first free layer 11 and the magnetization of the second free layer 13 are stabilized in an antiparallel arrangement to each other in a state in which no external magnetic field is applied. In addition, the magnetization of the first free layer 11 and the magnetization of the second free layer 13 are arranged in parallel to each other in a state in which the strength of an external magnetic field applied in the magnetization hard axis direction of the first free layer 11 and the second free layer 13 reaches that of the saturation magnetic field. Here, the antiparallel arrangement means a magnetization arrangement state in which the angle formed between the magnetization of the first free layer and the magnetization of the second free layer is maximized (180 degrees) and the resistance of the element is maximized. When the external magnetic field is increased, the angle formed between the magnetization of the first free layer and the magnetization of the second free layer is reduced, and the magnetizations of the first free layer and the second free layer are arranged in the same direction, that is, in parallel. In this case, the resistance of the element is minimized.

[2] In the magnetic junction according to the above aspect, until the strength of the external magnetic field applied in the magnetization hard axis direction of the first free layer 11 and the second free layer 13 reaches that of the saturation magnetic field, the magnetization of the first free layer 11 and the magnetization of the second free layer 13 rotate symmetrically with respect to a direction in which the external magnetic field is applied, the angle formed between the magnetization of the first free layer 11 and the magnetization of the second free layer 13 is reduced with an increase in strength of the external magnetic field, and as resistance magnetic field characteristics, even function characteristics symmetrical to positive/negative of the direction in which the external magnetic field is applied are exhibited.

[3] In the magnetic junction according to the above aspect, the tunnel barrier layer 12 may have any one selected from the group consisting of MgO, Mg-Al-O, and $Al_2O_3$, and the first free layer 11 and the second free layer 13 may have at least a layer consisting of CoFeB.

[4] In the magnetic junction according to the above aspect, at least one of the first free layer and the second free layer may be a stacked body including a plurality of layers. The stacked body has the layer consisting of CoFeB, a layer consisting of CoFe, and a central layer. The layer consisting of CoFe is at a position further away from the tunnel barrier layer 12 than the layer consisting of CoFeB, and the central layer is between the layer consisting of CoFeB and the layer consisting of CoFe. The central layer includes any one selected from the group consisting of NiFe, CoFeSiB, and CoFeBTa.

The layer consisting of CoFe is provided to improve the magnetic coupling, and the central layer is provided to improve soft magnetic characteristics.

[5] A TMR element according to a second aspect may have the magnetic junction according to the above aspect. The magnetic junction has a stacked structure body represented by

[ferromagnetic layer $A_i$/coupling layer $A_i]_n$/ferromagnetic layer $A_{n+1}$/intermediate layer A/first free layer/tunnel barrier layer/second free layer/intermediate layer B/[ferromagnetic layer $B_j$/coupling layer $B_j]_{n+1}$/ferromagnetic layer $B_{n+2}$/ or [ferromagnetic layer $A_j$/coupling layer $A_j]_{n+1}$/ferromagnetic layer $A_{n+2}$/intermediate layer A/first free layer/tunnel barrier layer/second free layer/intermediate layer B/[ferromagnetic layer $B_i$/coupling layer $B_i]_n$/ferromagnetic layer $B_{n+1}$/.

Here, n is an integer of 0 or more, when $n \neq 0$, i = 1, ..., n and j = 1, ..., n+1, the notation of [ferromagnetic layer $A_j$/coupling layer $A_j]_{n+1}$ means that a two-layer structure consisting of "ferromagnetic layer $A_j$/coupling layer $A_j$" is repeatedly stacked n+1 times, and the notation of [ferromagnetic layer $B_i$/coupling layer $B_i]_n$ means that a two-layer structure consisting of "ferromagnetic layer $B_i$/coupling layer $B_i$" is repeatedly stacked n times.

[6] In the TMR element according to the above aspect, the ferromagnetic layer $A_i$, the ferromagnetic layer $A_{n+1}$, the ferromagnetic layer $B_j$, the ferromagnetic layer $B_{n+2}$, the ferromagnetic layer $A_j$, and the ferromagnetic layer $B_i$ may be CoFe, the coupling layer $A_i$, the coupling layer $B_j$, the coupling layer $A_j$, and the coupling layer $B_i$ may be Ru, the intermediate layer A and the intermediate layer B may have at least one selected from the group consisting of Cu, Ag, Cr, Ru, and AgSn, the tunnel barrier layer may have any one selected from the group consisting of MgO, Mg-Al-O, and

$Al_2O_3$, and the first free layer and the second free layer may have at least a layer consisting of CoFeB.

[7] The TMR element according to the above aspect may have the magnetic junction according to the above aspect. The magnetic junction may have a stacked structure body represented by

first antiferromagnetic layer/first ferromagnetic layer/first exchange coupling layer/first free layer/tunnel barrier layer/second free layer/second exchange coupling layer/second ferromagnetic layer/second antiferromagnetic layer/,

the first exchange coupling layer and the second exchange coupling layer may be Ru or Cr, and one of magnetic coupling between the first ferromagnetic layer and the first free layer and magnetic coupling between the second ferromagnetic layer and the second free layer may be antiferromagnetic coupling, and the other may be ferromagnetic coupling.

[8] In the TMR element according to the above aspect, the first antiferromagnetic layer and the second antiferromagnetic layer may be at least one of IrMn, PtMn, FeMn, and NiMn, the first ferromagnetic layer and the second ferromagnetic layer may be CoFe, the first exchange coupling layer and the second exchange coupling layer may be Ru, the tunnel barrier layer may be one selected from the group consisting of MgO, Mg-Al-O, and $Al_2O_3$, and the first free layer and the second free layer may have at least a layer consisting of CoFeB.

[9] The TMR element according to the above aspect may have the magnetic junction according to the above aspect. The magnetic junction may have a stacked structure body represented by

antiferromagnetic layer A/dust layer A/[ferromagnetic layer $A_i$/coupling layer $A_i]_n$/first free layer/tunnel barrier layer/second free layer/[coupling layer $B_j$/ferromagnetic layer $B_j]_{n+1}$/dust layer B/antiferromagnetic layer B/ or antiferromagnetic layer A/dust layer A/[ferromagnetic layer $A_j$/coupling layer $A_j]_{n+1}$/first free layer/tunnel barrier layer/second free layer/[coupling layer $B_i$/ferromagnetic layer $B_i]_n$/dust layer B/antiferromagnetic layer B/.

Here, n is an integer of 0 or more, when n ≠ 0, i = 1, ..., n and j = 1, ..., n+1, the notation of [ferromagnetic layer $A_j$/coupling layer $A_j]_{n+1}$ means that a two-layer structure consisting of "ferromagnetic layer $A_j$/coupling layer $A_j$" is repeatedly stacked n+1 times, and the notation of [coupling layer $B_i$/ferromagnetic layer $B_i]_n$ means that a two-layer structure consisting of "coupling layer $B_i$/ferromagnetic layer $B_i$" is repeatedly stacked n times.

[10] In the TMR element according to the above aspect, the antiferromagnetic layer A and the antiferromagnetic layer B may have at least one selected from the group consisting of IrMn, PtMn, FeMn, and NiMn, the ferromagnetic layer $A_i$, the ferromagnetic layer $B_j$, the ferromagnetic layer $A_j$, and the ferromagnetic layer $B_i$ may be CoFe, the coupling layer $A_i$, the coupling layer $B_j$, the coupling layer $A_j$, and the coupling layer $B_i$ may be Ru, the dust layer A and the dust layer B may be Ru having a thickness of 1 nm or less, the tunnel barrier layer may have at least one selected from the group consisting of MgO, Mg-Al-O, and $Al_2O_3$, and the first free layer and the second free layer may have at least a layer consisting of CoFeB.

[11] In the TMR element according to the above aspect, the maximum resistance may be exhibited in a state in which the detection-target magnetic field is zero, and the magnetization of the first free layer and the magnetization of the second free layer may be arranged in an antiparallel manner. In addition, in the TMR element, by application of the detection-target magnetic field, the resistance is reduced, both of the magnetizations of the first free layer and the second free layer rotate, and the angle formed between the magnetization of the first free layer and the magnetization of the second free layer is reduced with an increase in strength of the detection-target magnetic field.

[12] In the TMR element according to the above aspect, when a direction in which the detection-target magnetic field is applied is inclined by 10° from the direction in the magnetization hard axis direction of the first free layer and the second free layer, magnetic field asymmetry of the resistance value with respect to positive/negative of the direction in which a magnetic field H1 is applied may be within 1%, and more preferably 0.5%. Here, the magnetic field H1 is a magnetic field in which a standardized value obtained by dividing the difference between a curve based on experimental data of resistance magnetic field (R-H) characteristics and a tangent determined with respect to the curve based on the experimental data at a point where the differential (dR/dH) of the curve based on the experimental data is maximized, by the maximum resistance value of the experimental data, is 20%. In addition, for the magnetic field asymmetry, when the element resistance R is represented by R(H) as a function of a magnetic field H, asymmetry of an R-H curve when H = H' (> 0) is defined by

$$Asy(H') = [R(H') - R(-H')]/[(R(H') + R(-H')] (\%)$$

to define asymmetry of a resistance with respect to the magnetic field H1.

[13] In the TMR element according to the above aspect, the stacked structure body may be positioned between a first structure consisting of substrate/lower electrode/under layer/antiferromagnetic layer and a second structure consisting of antiferromagnetic layer/cap layer.

[14] In the TMR element according to the above aspect, the stacked structure body may be positioned between a third structure consisting of substrate/lower electrode/under layer and a fourth structure consisting of a cap layer.

[15] In the TMR element according to the above aspect, the substrate may be a silicon wafer, or a ceramic wafer consisting of AlTiC or alumina, the under layer may have a stacked configuration consisting of Ta and Ru, the antiferromagnetic layer may be any one selected from the group consisting of IrMn, PtMn, FeMn, and NiMn, and the cap layer may be Ru.

[16] A magnetic sensor according to a third aspect has a bridge circuit using four TMR elements according to the above aspect.

[17] A TMR element array according to a fourth aspect has a plurality of the TMR elements according to the above aspect connected in at least one of series and parallel.

[18] The magnetic sensor according to the above aspect may have the TMR element array according to the above aspect, provided by bridge circuit connection.

[19] A magnetic sensor for a linear encoder according to a fifth aspect or a magnetic rotary encoder according to a sixth aspect has the TMR element according to the above aspect or the magnetic sensor according to the above aspect.

Advantageous Effects of Invention

A TMR element of the present disclosure exhibits even function R-H characteristics and exhibits a resistance change ratio of more than 150% that is equal to that of an odd function spin valve type. The resistance change ratio is equivalent to about 1.5 times that of a single soft pin type TMR sensor. Therefore, a magnetic sensor including the TMR element of the present disclosure has high sensitivity and can detect a position with higher accuracy.

In the TMR element of the present disclosure, even in a case where a direction of a detection-target magnetic field deviates from a magnetization hard axis direction of the free layer, the asymmetry of R-H characteristics is smaller than that in a single soft pin type of the related art, and thus it is possible to detect a position with higher accuracy and obtain exceptional mounting properties.

In the TMR element of the present disclosure, it is possible to adjust a saturation magnetic field according to the position detection magnetic field by devising the thickness of the intermediate layer, the exchange coupling layer, or the dust layer.

Brief Description of Drawings

FIG. 1 is a diagram explaining magnetization states and resistance magnetic field characteristics of a magnetic junction according to a first embodiment and shows magnetization directions of free layers (ferromagnetic layers) in typical three magnetization modes.

FIG. 2A is a diagram showing a stacked structure body of a first example (n = 0) of a first stacking pattern of the magnetic sensor according to the first embodiment.

FIG. 2B is a diagram showing a stacked structure body of a second example (n ≥ 1) of the first stacking pattern of the magnetic sensor according to the first embodiment.

FIG. 2C is a diagram showing a stacked structure body of a first example (n ≥ 1) of a second stacking pattern of the magnetic sensor according to the first embodiment.

FIG. 3A is a diagram showing a stacked structure body of a first example (n = 0) of a first stacking pattern of a magnetic sensor according to a second embodiment.

FIG. 3B is a diagram showing a stacked structure body of a second example (n ≥ 1) of the first stacking pattern of the magnetic sensor according to the second embodiment.

FIG. 3C is a diagram showing a stacked structure body of a third example (n ≥ 1) of a second stacking pattern of the magnetic sensor according to the second embodiment.

FIG. 4 is a diagram showing a stacked structure body of a first example of a third stacking pattern of a magnetic sensor according to a third embodiment.

FIG. 5A is a diagram showing a stacked structure body of a first example (n = 0) of a fourth stacking pattern of a magnetic sensor according to a fourth embodiment.

FIG. 5B is a diagram showing a stacked structure body of a second example (n ≥ 1) of the fourth stacking pattern of the magnetic sensor according to the fourth embodiment.

FIG. 5C is a diagram showing a stacked structure of a first example (n ≥ 1) of a fifth stacking pattern of the magnetic sensor according to the fourth embodiment.

FIG. 6 is a diagram showing a stacked structure of a TMR sensor including a magnetic sensor of the first to fifth stacking patterns.

FIG. 7 is a diagram showing a resistance-magnetic field curve of a stacked body having a first stacking pattern of a stacked structure shown in Table 1, that is an example of the present invention, in which a broken line and a solid line indicate different combinations of thicknesses of an intermediate layer A and an intermediate layer B.

FIG. 8A is a diagram showing magnetization curves of a first free layer of a stacked body (n = 0) having the first stacking pattern.

FIG. 8B is a diagram showing a relationship between a thickness of an intermediate layer and a soft pin magnetic field strength Hpin of a free layer in various stacked configurations.

FIG. 9 is a diagram showing a definition of a magnetic field H1 in a resistance-magnetic field curve.

FIG. 10A is a diagram showing an angle of deviation (θ) of a magnetic field application angle of a magnetic sensor having a configuration of Table 1.

FIG. 10B is a diagram showing changes of a resistance-magnetic field curve in a case where the angle of deviation (θ) of the magnetic field application angle of the magnetic sensor having the configuration of Table 1 varies.

FIG. 10C is a diagram explaining a resistance change ratio of a stacked body having the third stacking pattern due to a difference in annealing temperature.

FIG. 11 is a diagram showing changes in asymmetry of a resistance-magnetic field curve in the magnetic field H1 due to the angle of deviation (θ) of the magnetic field application angle of the magnetic sensor between an example and a comparative example.

FIG. 12A is a diagram showing results of simulation of H1 asymmetry of a dual soft pin TMR sensor according to the present embodiment.

FIG. 12B is a diagram showing results of simulation of H1 asymmetry of a single soft pin TMR sensor that is the comparative example.

FIG. 13A is a diagram showing results of simulation of a resistance-magnetic field curve of the dual soft pin TMR sensor according to the present embodiment.

FIG. 13B is a diagram showing results of simulation of a resistance-magnetic field curve of the single soft pin TMR sensor that is the comparative example.

FIG. 14A is a configuration perspective view showing an example in which a plurality of TMR element portions of the dual soft pin TMR sensor according to the present embodiment are connected in series.

FIG. 14B is a configuration perspective view showing an example in which a plurality of TMR element portions of the dual soft pin TMR sensor according to the present embodiment are connected in a combination of series and parallel.

FIG. 15 is a circuit diagram of an encoder having a bridge configuration according to the present embodiment.

FIG. 16A is a configuration sectional view of a stacked structure of a superlattice type GMR sensor, and also shows magnetization directions of ferromagnetic layers.

FIG. 16B is a resistance-magnetic field curve of the stacked structure of the superlattice type GMR sensor.

FIG. 17 is a diagram showing a resistance-magnetic field curve of a spin valve type TMR sensor, and also shows magnetization directions of free layers (ferromagnetic layers) in typical three magnetization modes.

FIG. 18 is a diagram showing a resistance-magnetic field curve of a soft pin type TMR sensor, and also shows magnetization directions of free layers (ferromagnetic layers) in typical three magnetization modes.

FIG. 19 is a diagram showing an example of a resistance change ratio-magnetic field curve of a granular TMR.

FIG. 20 is a configuration perspective view of a magnetic linear encoder to which the magnetic sensor according to the present embodiment is applied.

FIG. 21 is a configuration view of a magnetic rotary encoder to which the magnetic sensor according to the present embodiment is applied.

Description of Embodiments

Hereinafter, the best mode for carrying out the present disclosure will be described in detail.

As a magnetic sensor of the present disclosure, a tunnel magnetoresistance (TMR) element may be used, and the magnetic sensor basically has a three-layer structure consisting of a first free layer (ferromagnetic metal), a tunnel barrier layer (insulator oxide), and a second free layer (ferromagnetic metal). The tunnel barrier layer is interposed between the first free layer and the second free layer, and the first free layer and the second free layer are magnetically separated. The TMR element exhibits a tunnel magnetoresistance effect, and in a case where a voltage is applied between the first free layer and the second free layer, the resistance value of the sensor changes depending on a relative angle of magnetization between the first free layer and the second free layer.

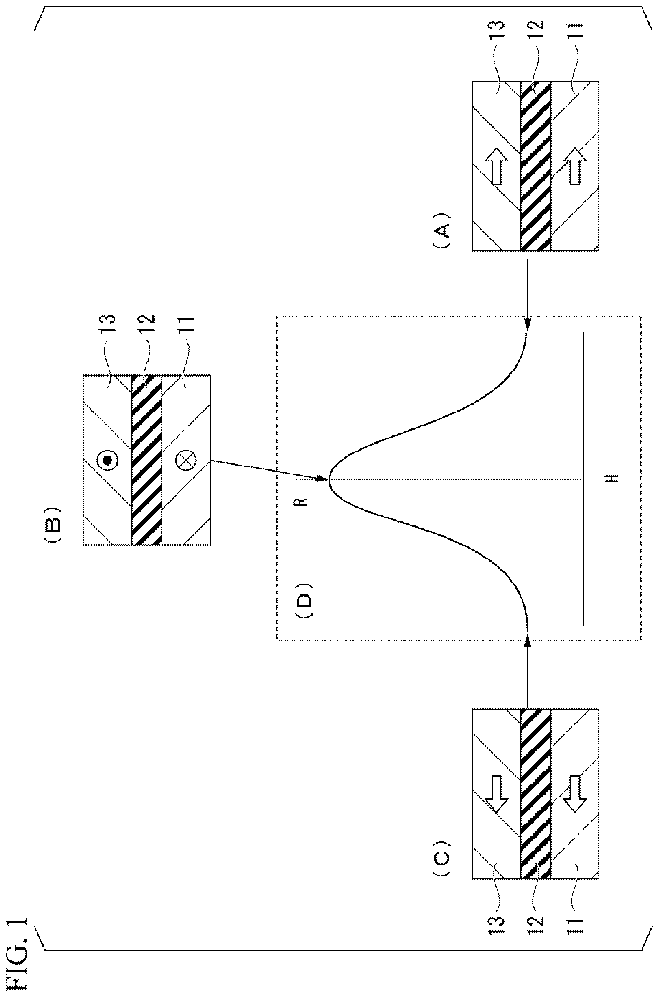

As shown in (A) to (C) of FIG. 1, the magnetic sensor of the present disclosure has a first free layer 11, a tunnel barrier layer 12, and a second free layer 13. The tunnel barrier layer 12 is interposed between the first free layer 11 and the second free layer 13. The first free layer 11 and the second free layer 13 are ferromagnetic layers, and are preferably formed of, for example, CoFeB, but are not limited thereto. As the tunnel barrier layer 12, at least one selected from the group consisting of MgO, Mg-Al-O, and $Al_2O_3$ is preferably used. In addition, the first free layer 11 or the second free layer 13 may be a stacked body including a plurality of layers. The stacked body has, for example, a layer consisting of CoFeB, a layer consisting of CoFe, and an intermediate layer. CoFeB having exceptional TMR characteristics is preferably disposed close to the tunnel barrier layer 12, and CoFe may be disposed in the vicinity of a boundary face with another layer at a position away from the tunnel barrier layer 12. The intermediate layer is disposed between these layers, and NiFe, CoFeSiB, CoFeBTa, or the like having exceptional soft magnetism can be used.

As shown in (B) of FIG. 1, magnetizations of the first free layer 11 and the second free layer 13 between which the tunnel barrier layer 12 is interposed are stabilized in an antiparallel arrangement to each other under no magnetic field. The magnetic sensor is disposed so that a detection-target magnetic field is applied in a vertical direction (a hard axis direction of the free layer), for example.

In a case where an external magnetic field is applied in the magnetization hard axis direction of the first free layer 11 and the second free layer 13 (a direction orthogonal to the magnetization direction of the first free layer 11 and the second free layer 13 under no magnetic field), the magnetizations of the first free layer 11 and the second free layer 13 rotate symmetrically with respect to the direction of the external magnetic field. The angle formed between the magnetization of the first free layer 11 and the magnetization of the second free layer 13 is reduced with an increase in strength of the external magnetic field, and the state of (A) or (C) of FIG. 1 is obtained. In the states of (A) and (B) of FIG. 1, the element resistance is lower than that in the state of (C) of FIG. 1. The unidirectional magnetic anisotropies of the magnetizations of the first free layer 11 and the second free layer 13 are set to a strength suitable for the magnitude of the detection-target magnetic field as described below. The magnitude of the saturation magnetic field and the magnetic permeability of the free layer are determined by the strength (soft pin magnetic field strength) of the magnetic anisotropy.

(D) of FIG. 1 shows a relationship between the magnetic field and the resistance in the magnetic sensor of the present disclosure. As shown in FIG. 1(D), the magnetoresistance of the element is maximized under no magnetic field, and decreases with an increase in external magnetic field strength. In a case where an external magnetic field is applied in the magnetization hard axis direction of the first free layer 11 and the second free layer 13, the magnetizations of the first free layer 11 and the second free layer 13 rotate symmetrically with respect to the external magnetic field, and the angle formed between the magnetization of the first free layer 11 and the magnetization of the second free layer 13 is reduced with an increase in external magnetic field strength. The magnetic sensor of the present disclosure can obtain even function resistance magnetic field characteristics symmetrical to the positive/negative sign of the external magnetic field. The sign of the external magnetic field is defined as positive in, for example, one direction of the magnetization hard axis direction and is defined as negative in the opposite direction.

The following aspects are considered as a specific stacked structure of the TMR sensor in the magnetic sensor of the present disclosure. In the present specification, the magnetic sensor according to the present disclosure will be referred to as "dual soft pin TMR sensor" hereinbelow.

Representative materials of the layers of the magnetic sensor of the present disclosure are as follows. A stacked configuration in which Ta and Ru are stacked can be used as a under layer. Any one or more selected from the group consisting of IrMn, PtMn, FeMn, and NiMn can be used as an antiferromagnetic material. CoFe can be used as a ferromagnetic layer. Ru can be used as a coupling layer. A non-magnetic material such as Cu, Ag, Cr, or Ru, preferably AgSn, can be used as an intermediate layer. Ru can be used as a cap layer.

In addition, in the following first stacking pattern and second stacking pattern, the lowermost and uppermost ferromagnetic layers in the stacked structure may be replaced with a hard magnetic film such as CoPt without using the antiferromagnetic layer.

The free layer (first free layer 11 and second free layer 13) may have a single layer structure consisting of a layer consisting of CoFeB, but may have a stacked configuration to further increase the magnetic characteristics. The stacked configuration of the free layer may have, for example, a layer consisting of CoFeB, a layer consisting of CoFe, and a central layer. The layer consisting of CoFeB having exceptional TMR is provided closer to the tunnel barrier layer 12 side than the layer consisting of CoFe. NiFe, CoFeSiB, CoFeBTa, or the like having exceptional soft magnetism is used for a central portion between the layer consisting of CoFeB and the layer consisting of CoFe.

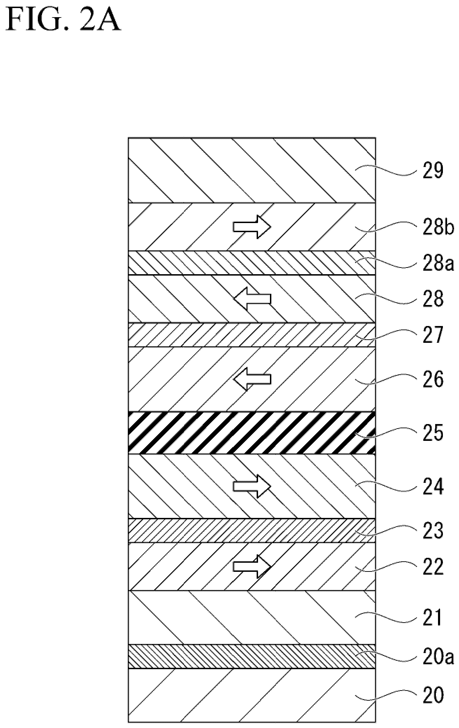

FIG. 2A is a diagram showing a first example (n = 0) of a stacked structure body having a first stacking pattern according to the first embodiment.

The stacked structure body of the first example (n = 0) of the first stacking pattern has a stacked structure represented by electrode 20/under layer 20a/antiferromagnetic layer 21/ferromagnetic layer 22/intermediate layer 23/first free layer 24/tunnel barrier layer 25/second free layer 26/intermediate layer 27/ferromagnetic layer 28/coupling layer 28a/ferromagnetic layer 28b/antiferromagnetic layer 29/cap layer (not shown). Here, "/" represents a stacking interface between the layers, and the layers are stacked in this order with "/" interposed therebetween.

The intermediate layers 23 and 27 are, for example, AgSn. Ferromagnetic interlayer coupling acts between the ferromagnetic layer 22 and the first free layer 24 between which the intermediate layer 23 is interposed, and ferromagnetic interlayer coupling acts between the ferromagnetic layer 28 and the second free layer 26 between which the intermediate layer 27 is interposed. The coupling layer 28a is, for example, Ru and firmly couples the ferromagnetic layers 28 and 28b on both sides between which the coupling layer 28a is interposed in an antiparallel manner.

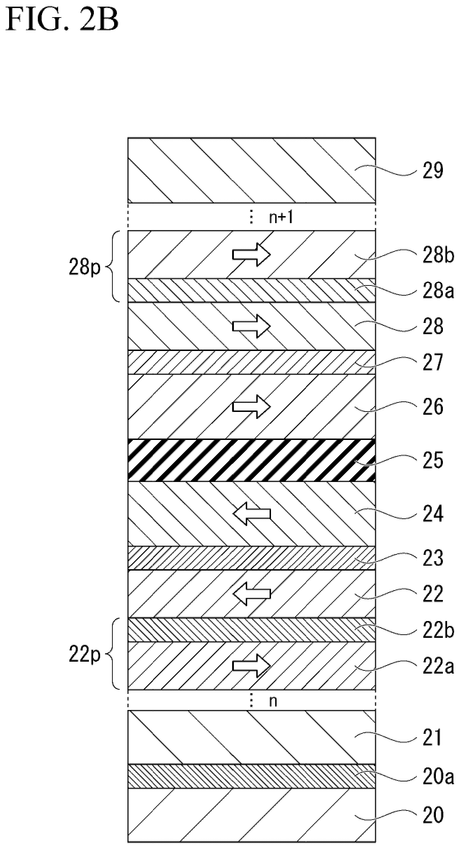

FIG. 2B is a diagram showing a second example ($n \geq 1$) of the stacked structure body having the first stacking pattern according to the first embodiment.

The stacked structure body of the second example ($n \geq 1$) of the first stacking pattern has a stacked structure represented by electrode 20/under layer 20a/antiferromagnetic layer 21/stacked body 22p (= [ferromagnetic layer 22a/coupling layer 22b] repeated n times)/ferromagnetic layer 22/intermediate layer 23/first free layer 24/tunnel barrier layer 25/second free layer 26/intermediate layer 27/ferromagnetic layer 28/stacked body 28p (= [coupling layer 28a/ferromagnetic layer 28b] repeated n+1 times)/antiferromagnetic layer 29/cap layer (not shown).

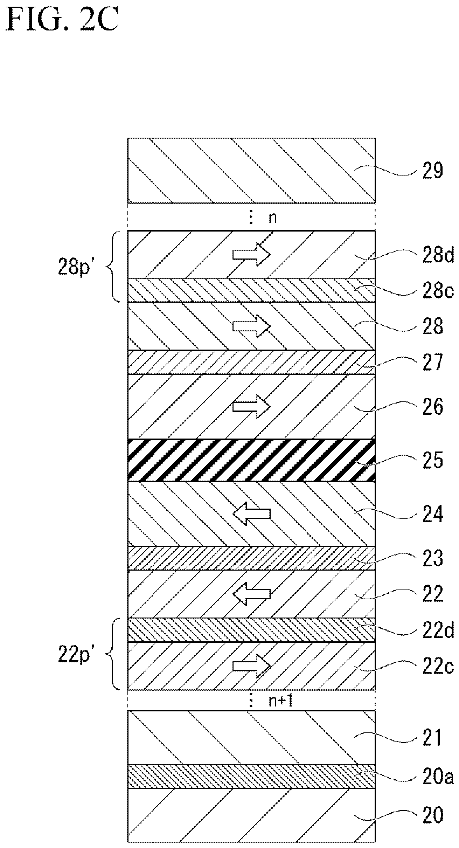

FIG. 2C is a diagram showing a first example ($n \geq 1$) of a stacked structure having a second stacking pattern according to the first embodiment. In FIG. 2C, the stacking order of [ferromagnetic layer 22a/coupling layer 22b]n and [coupling layer 28a/ferromagnetic layer 28b]n+1 is changed in the stacked body having the first stacking pattern shown in FIG. 2B.

The first example ($n \geq 1$) of the second stacking pattern has a stacked structure represented by electrode 20/under layer 20a/antiferromagnetic layer 21/stacked body 22p' (= [ferromagnetic layer 22c/coupling layer 22d] repeated n+1 times)/ferromagnetic layer 22/intermediate layer 23/first free layer 24/tunnel barrier layer 25/second free layer 26/intermediate layer 27/ferromagnetic layer 28/stacked body 28p' (= [coupling layer 28c/ferromagnetic layer 28d] repeated n times)/antiferromagnetic layer 29/cap layer (not shown).

Here, the stacked structure body having the first stacking pattern ($n \geq 1$) shown in FIG. 2B can also be expressed as follows by a general formula.

First stacking pattern: under layer/antiferromagnetic layer A/[ferromagnetic layer $A_i$/coupling layer $A_i]_n$/ferromagnetic layer $A_{n+1}$/intermediate layer A/first free layer/tunnel barrier layer/second free layer/intermediate layer B/[ferromagnetic layer $B_j$/coupling layer $B_j]_{n+1}$/ferromagnetic layer $B_{n+2}$/antiferromagnetic layer B/cap layer

In addition, the stacked structure body having the second stacking pattern ($n \geq 1$) shown in FIG. 2C can also be expressed as follows by a general formula.

Second stacking pattern: under layer/antiferromagnetic layer A/[ferromagnetic layer $A_j$/coupling layer $A_j]_{n+1}$/ferromagnetic layer $A_{n+2}$/intermediate layer A/first free layer/tunnel barrier layer/second free layer/intermediate layer B/[ferromagnetic layer $B_j$/coupling layer $B_j]_n$/ferromagnetic layer $B_{n+1}$/antiferromagnetic layer B/cap layer

Here, n is an integer of 0 or more. When $n \neq 0$, i = 1, ..., n and j = 1, ..., n+1. [Ferromagnetic layer $A_j$/coupling layer $A_j]_{n+1}$ means that the two-layer structure consisting of "ferromagnetic layer $A_j$/coupling layer $A_j$" is repeatedly stacked n+1 times. That is, when n = 1, [ferromagnetic layer $A_j$/coupling layer $A_j]_{n+1}$/ferromagnetic layer $A_{n+2}$ is a stacked body consisting of ferromagnetic layer $A_1$/coupling layer $A_1$/ferromagnetic layer $A_2$/coupling layer $A_2$/ferromagnetic layer $A_3$.

An operation of the device configured as described above will be described.

The magnetization of the first free layer and the magnetization of the second free layer are arranged in an antiparallel manner under no magnetic field. Means for realizing the arrangement is as follows. The ferromagnetic layer A is stacked on the antiferromagnetic layer A. The antiferromagnetic layer B is stacked on the ferromagnetic layer B. When $n \neq 0$, any one of: the number of times of stacking of ferromagnetic layer/coupling layer in the stacked body including the magnetic layer A; and the number of times of stacking of ferromagnetic layer/coupling layer in the stacked body including the magnetic layer B is an even number, and the other is an odd number. In addition, the magnetizations of the ferromagnetic layers on both sides between which the coupling layer is interposed are magnetically coupled to each other in an antiparallel manner. After formation of the stacked structure, in a case where the structure is heat-treated (at about 300°C) under a magnetic field and the temperature is returned to room temperature, the magnetizations of the ferromagnetic layer A and the ferromagnetic layer B are fixed in the same direction by an unidirectional magnetic anisotropy. The magnetization of the first free layer and the magnetization of the second free layer have unidirectional magnetic anisotropies in opposite directions via the antiparallel magnetic coupling of the coupling layer, and the magnetization of the first free layer and the magnetization of the second free layer are arranged in an antiparallel manner under no magnetic field.

In the first stacking pattern and the second stacking pattern, in a case where an external magnetic field is applied in the hard axis direction of the first free layer and the second free layer (a direction orthogonal to the magnetization direction of the first free layer and the second free layer under no magnetic field), the magnetizations of the first free layer and the second free layer rotate symmetrically with respect to the direction of the external magnetic field. The angle formed between the magnetization of the first free layer and the magnetization of the second free layer is reduced with an increase in strength of the external magnetic field, and the element resistance decreases. Therefore, the stacked structure bodies each having the first stacking pattern or the second stacking pattern exhibit even function resistance magnetic field characteristics symmetrical to the positive/negative of the direction in which the external magnetic field is applied. The magnitude of the saturation magnetic field and the magnetic permeability of the free layer are determined by the soft pin strengths of the first free layer and the second free layer, but can be desirably adjusted by the thickness and material (AgSn or the like) of the intermediate layer.

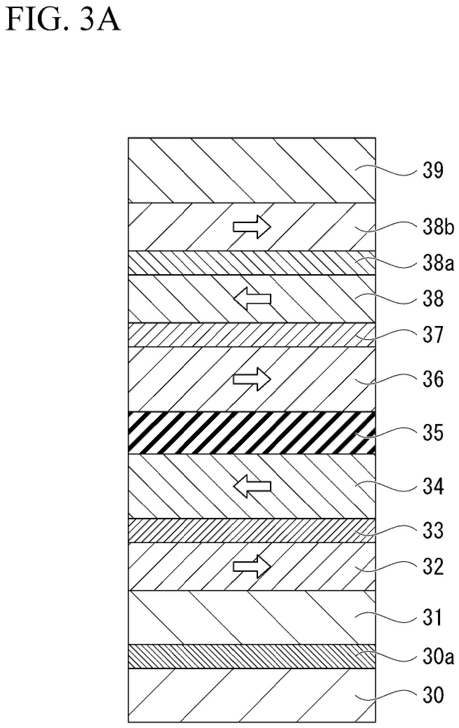

FIG. 3A is a diagram showing a first example (n = 0) of a stacked structure body having a first stacking pattern according to a second embodiment. The stacked structure body shown in FIG. 3A is a modification example of the stacked structure body having the first stacking pattern (n = 0) shown in FIG. 2A.

The first example (n = 0) of the first stacking pattern according to the second embodiment has a stacked structure represented by electrode 30/under layer 30a/antiferromagnetic layer 3 1/ferromagnetic layer 32/intermediate layer 33/first free layer 34/tunnel barrier layer 35/second free layer 36/intermediate layer 37/ferromagnetic layer 38/coupling layer 38a/ferromagnetic layer 38b/antiferromagnetic layer 39/cap layer (not shown).

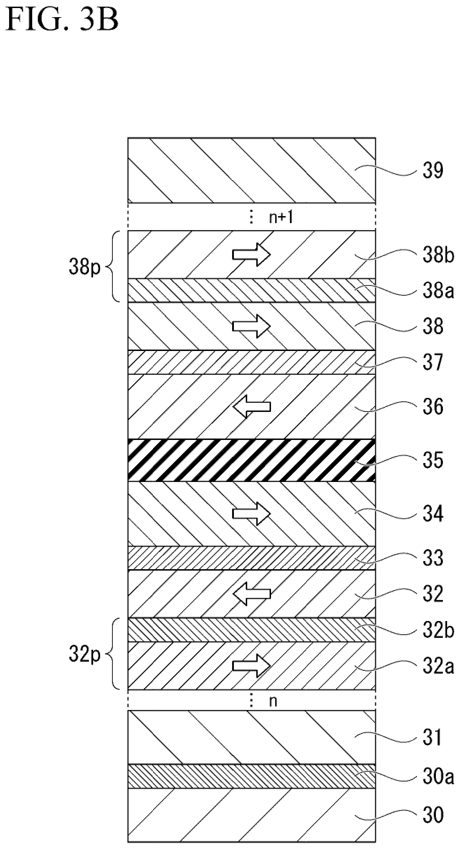

FIG. 3B is a diagram showing a second example (n ≥ 1) of the stacked structure body having the first stacking pattern according to the second embodiment. The stacked structure body shown in FIG. 3B is a modification example of the stacked structure body having the first stacking pattern (n ≥ 1) shown in FIG. 2B.

The second example (n ≥ 1) of the first stacking pattern according to the second embodiment has a stacked structure represented by electrode 30/under layer 30a/antiferromagnetic layer 31/stacked body 32p (= [ferromagnetic layer 32a/coupling layer 32b] repeated n times)/ferromagnetic layer 32/intermediate layer 33/first free layer 34/tunnel barrier layer 35/second free layer 36/intermediate layer 37/stacked body 38p (= [ferromagnetic layer 38/coupling layer 38a/ferromagnetic layer 38b] repeated n+1 times)/antiferromagnetic layer 39/cap layer (not shown).

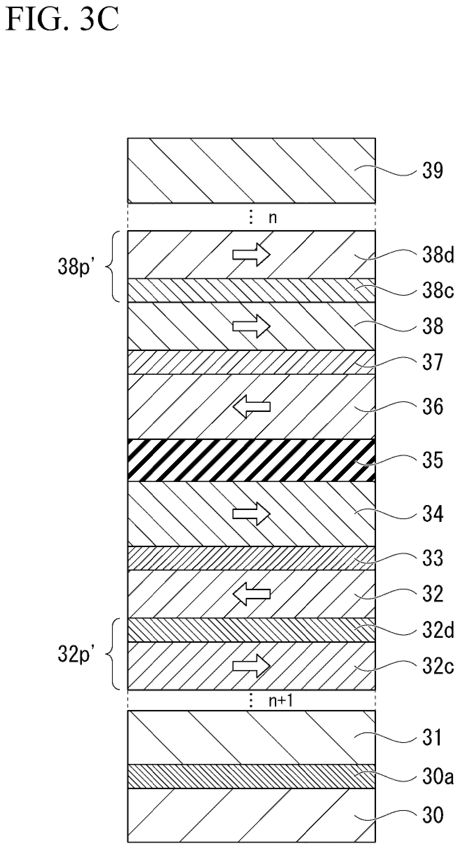

FIG. 3C is a diagram showing a first example (n ≥ 1) of a stacked structure body having a second stacking pattern according to the second embodiment. The stacked structure body shown in FIG. 3C is a modification example of the stacked structure body having the second stacking pattern (n ≥ 1) shown in FIG. 2C.

The first example (n ≥ 1) of the second stacking pattern according to the second embodiment is electrode 30/under layer 30a/antiferromagnetic layer 31/stacked body 32p' (= [ferromagnetic layer 32c/coupling layer 32d] repeated n+1 times)/ferromagnetic layer 32/intermediate layer 33/first free layer 34/tunnel barrier layer 35/second free layer 36/intermediate layer 37/ferromagnetic layer 38/stacked body 38p' (= [coupling layer 38c/ferromagnetic layer 38d] repeated n times)/antiferromagnetic layer 39/cap layer (not shown).

In the configurations shown in FIGS. 3A to 3C, the names of the layers shown in FIGS. 2A to 2C are the same, and the same configurations as those in FIGS. 2A to 2C can be used. The stacked bodies shown in FIGS. 3A to 3C are different from the stacked bodies shown in FIGS. 2A to 2C in which the magnetization directions of the ferromagnetic layers 22 and 28 are parallel to first free layer 24/tunnel barrier layer 25/second free layer 26, in that the magnetization directions of the ferromagnetic layers 32 and 38 are antiparallel to first free layer 34/tunnel barrier layer 35/second free layer 36.

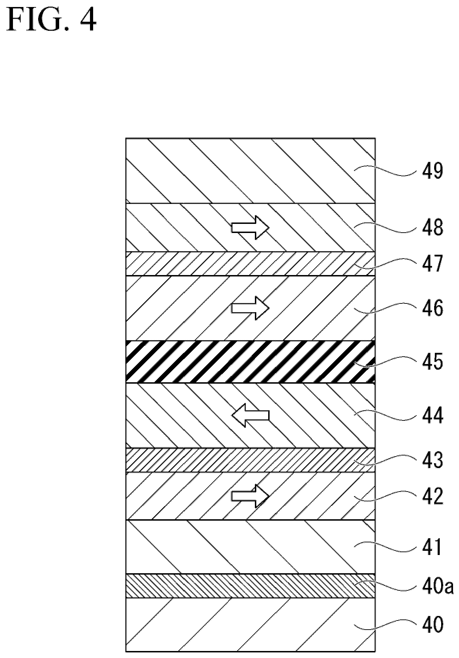

FIG. 4 is a diagram showing a stacked structure having a third stacking pattern according to a third embodiment.

The stacked structure having the third stacking pattern has a stacked structure represented by electrode 40/under layer 40a/antiferromagnetic layer 41/ferromagnetic layer 42/exchange coupling layer 43/first free layer 44/tunnel barrier layer 45/second free layer 46/exchange coupling layer 47/ferromagnetic layer 48/antiferromagnetic layer 49/cap layer (not shown).

Each of the exchange coupling layers 43 and 47 are Ru, Cr, Ir, Rh, or the like. Depending on the film thickness of the exchange coupling layer 43, the interlayer coupling between the ferromagnetic layer 42 and the first free layer 44 can be either of two types: antiferromagnetic coupling and ferromagnetic coupling. Depending on the film thickness of the exchange coupling layer 47, the interlayer coupling between the ferromagnetic layer 48 and the second free layer 46 can be either of two types: antiferromagnetic coupling and ferromagnetic coupling. In a case where the film thickness of the exchange coupling layer 43 is the film thickness with which the interlayer coupling between the ferromagnetic layer 42 and the first free layer 44 is antiferromagnetic coupling, the film thickness of the exchange coupling layer 47 is set to the film thickness with which the interlayer coupling between the ferromagnetic layer 48 and the second free layer 46 is ferromagnetic coupling. In a case where the film thickness of the exchange coupling layer 43 is set to the film thickness with which the arrangement of the magnetizations of the layers between which the exchange coupling layer 43 is interposed is ferromagnetic coupling, the film thickness of the exchange coupling layer 47 is set to the film thickness with which the arrangement of the magnetizations of the layers between which the exchange coupling layer 47 is interposed is antiferromagnetic coupling.

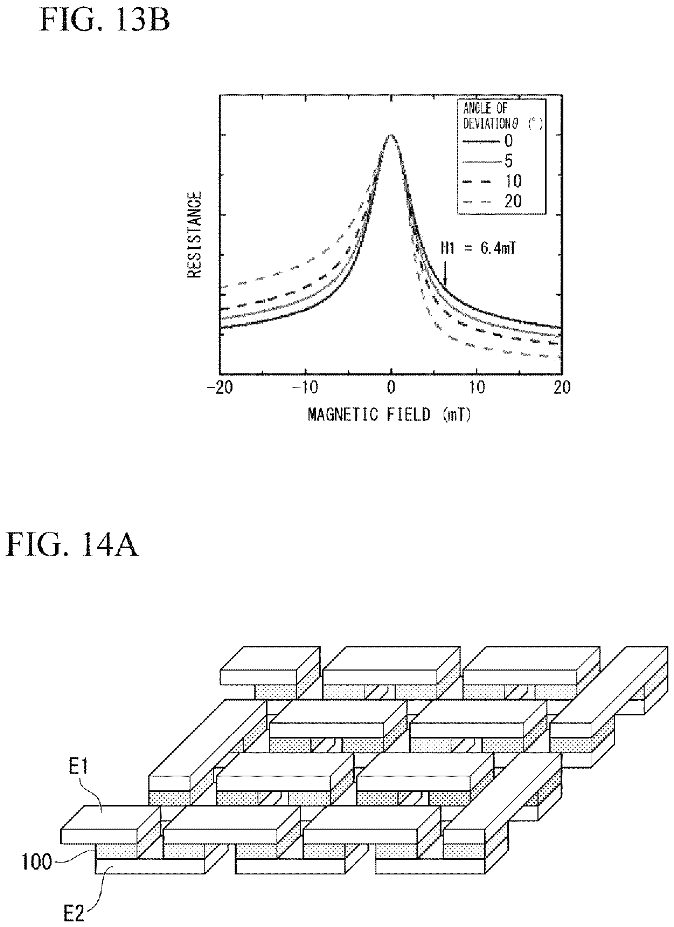

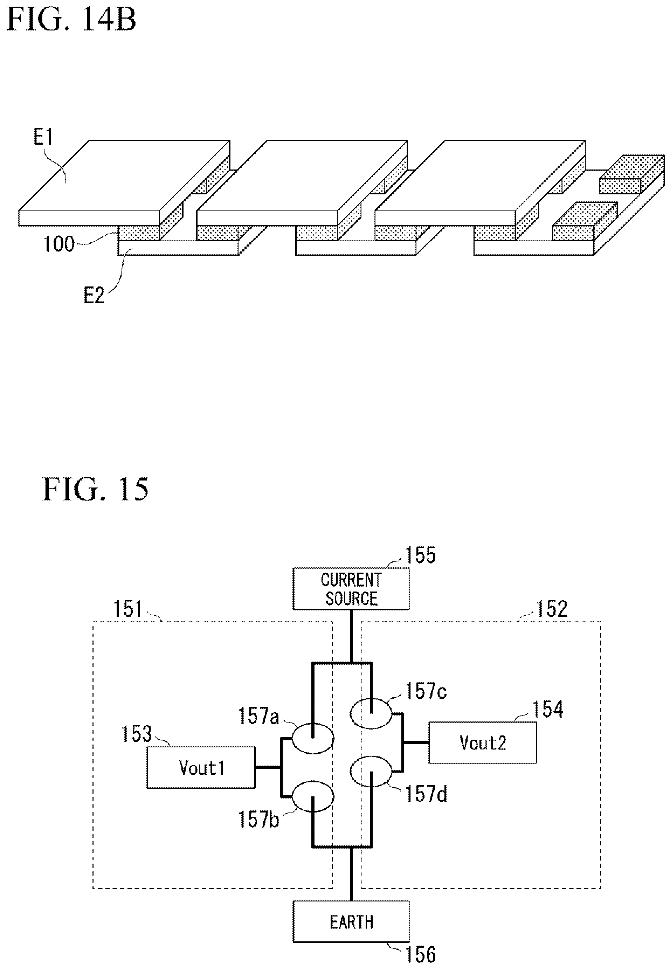

Characteristics of the third stacking pattern will be described later with reference to FIG. 14.

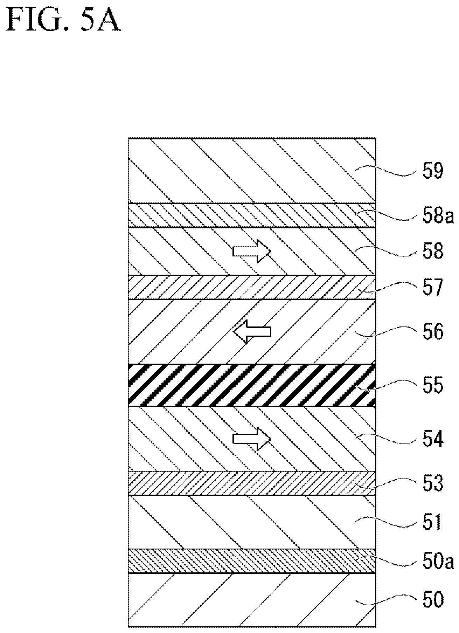

FIG. 5A is a diagram showing a first example (n = 0) of a stacked structure body having a fourth stacking pattern according to a fourth embodiment.

The first example (n = 0) of the fourth stacking pattern has a stacked structure represented by electrode 50/under layer 50a/antiferromagnetic layer 51/dust layer 53/first free layer 54/tunnel barrier layer 55/second free layer 56/coupling layer 57/ferromagnetic layer 58/dust layer 58a/antiferromagnetic layer 59/cap layer (not shown).

The dust layer 53 and the dust layer 58a are non-magnetic layers such as Ru having a thickness of 1 nm or less, and act to weaken the exchange bias of the antiferromagnetic material.

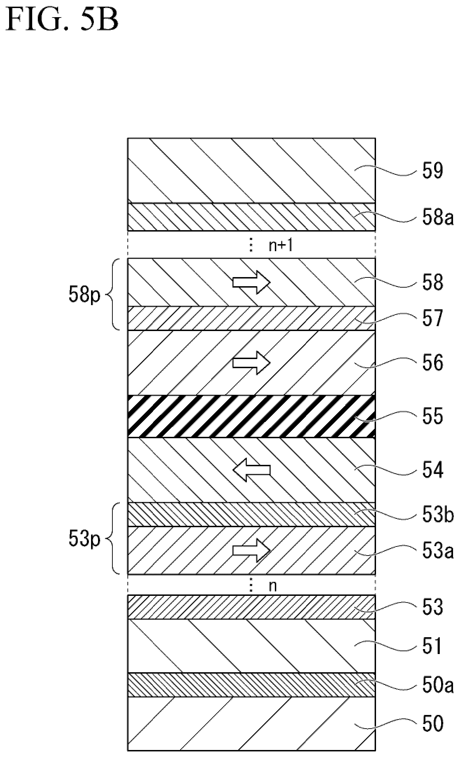

FIG. 5B is a diagram showing a second example (n ≥ 1) of the stacked structure body having the fourth stacking pattern according to the fourth embodiment.

The second example (n ≥ 1) of the fourth stacking pattern has a stacked structure represented by electrode 50/under layer 50a/antiferromagnetic layer 51/dust layer 53/stacked body 53p (= [ferromagnetic layer 53a/coupling layer 53b] repeated n times)/first free layer 54/tunnel barrier layer 55/second free layer 56/stacked body 58p (= [coupling layer 57/ferromagnetic layer 58] repeated n+1 times)/dust layer 58a/antiferromagnetic layer 59/cap layer (not shown).

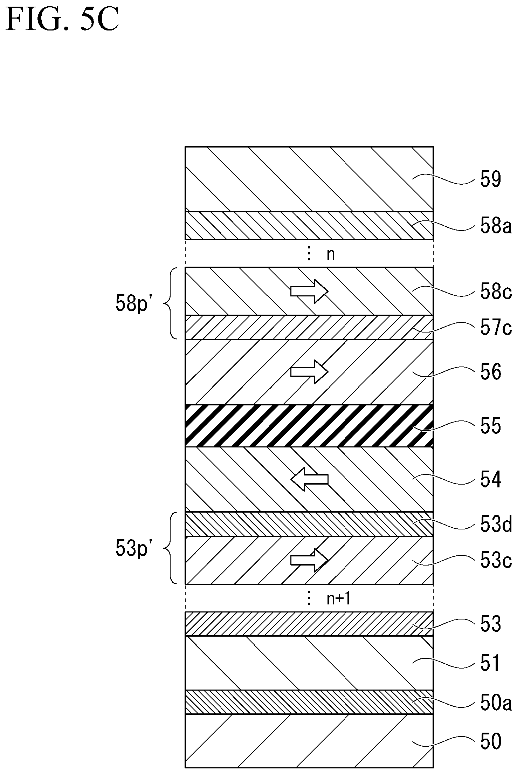

FIG. 5C is a diagram showing a first example (n ≥ 1) of a stacked structure body having a fifth stacking pattern according to the fourth embodiment.

The first example of the fifth stacking pattern (n ≥ 1) has a stacked structure represented by electrode 50/under layer 50a/antiferromagnetic layer 51/dust layer 53/stacked body 53p' (= [ferromagnetic layer 53c/coupling layer 53d] repeated n+1 times)/first free layer 54/tunnel barrier layer 55/second free layer 56/stacked body 58p' (= [coupling layer 57c/ferromagnetic layer 58c] repeated n times)/dust layer 58a/antiferromagnetic layer 59/cap layer (not shown).

Here, the stacked structure body of the second example (n ≥ 1) of the fourth stacking pattern shown in FIG. 5B can also be expressed as follows by a general formula.

Fourth stacking pattern: under layer/antiferromagnetic layer A/dust layer A/[ferromagnetic layer $A_i$/coupling layer $A_i]_n$/first free layer/tunnel barrier layer/second free layer/[coupling layer $B_j$/ferromagnetic layer $B_j]_{n+1}$/dust layer B/anti-ferromagnetic layer B/cap layer

In addition, the first example (n ≥ 1) of the stacked structure having the fifth stacking pattern shown in FIG. 5C can also be expressed as follows by a general formula.

Fifth stacking pattern: under layer/antiferromagnetic layer A/dust layer A/[ferromagnetic layer $A_j$/coupling layer $A_j]_{n+1}$/first free layer/tunnel barrier layer/second free layer/[coupling layer $B_i$/ferromagnetic layer $B_i]_n$/dust layer B/anti-ferromagnetic layer B/cap layer

Here, n is an integer of 0 or more. When n ≠ 0, i = 1, ..., n and j = 1, ..., n+1.

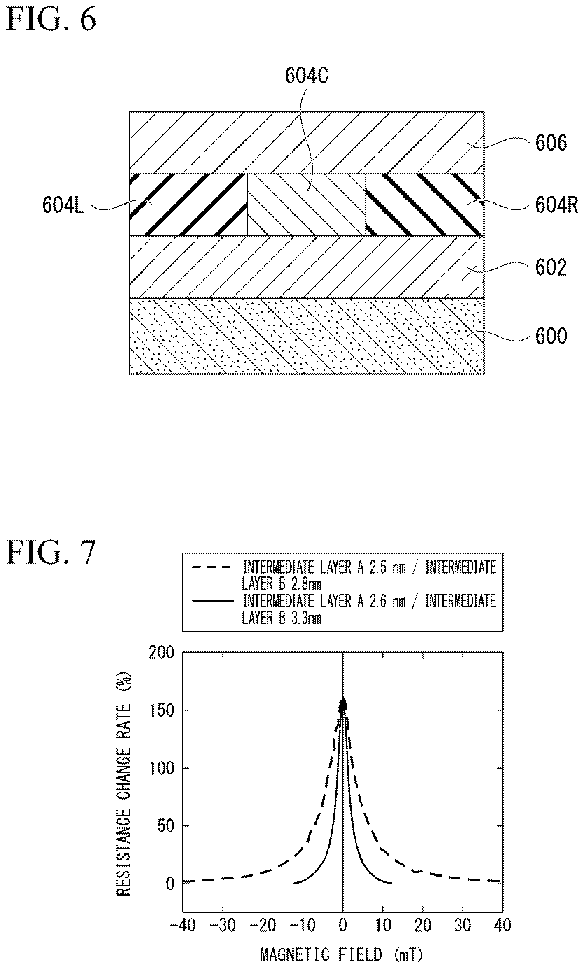

FIG. 6 is a diagram showing a configuration of a TMR sensor including a stacked structure body of the first to fifth stacking patterns.

The TMR sensor has a stacked structure consisting of substrate 600/lower electrode 602/stacked body layer 604C/upper electrode 606. The stacked body layer 604C is a stacked structure body having any one of the first to fifth stacking patterns. The stacked body layer 604C can be obtained by stacking layers and then performing patterning into a predetermined shape by photolithography or the like. The substrate 600 is a silicon wafer, or an AlTiC or alumina ceramic wafer, and Cu, Au, Ru, or the like is used for the lower electrode 602 and the upper electrode 606.

Insulating layers 604L and 604R are provided in adjacent left and right regions of the stacked body layer 604C.

<Magnetic Characteristic Evaluation Example 1: Film Configuration and R-H Characteristics>

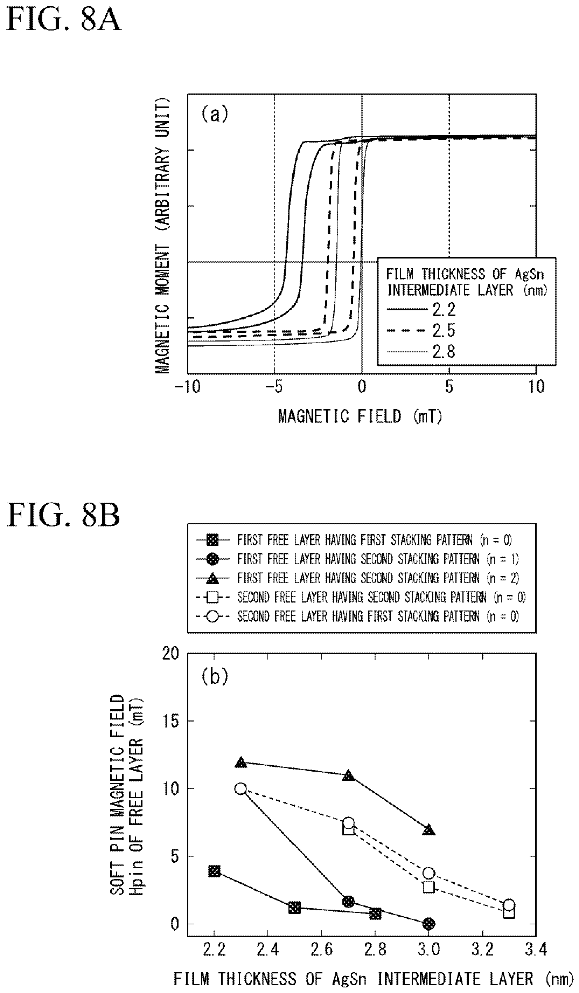

A TMR sensor having a structure with a stacking pattern 1 (n = 0) shown in Table 1 was produced. The TMR sensor has a stacked structure having the first stacking pattern (n = 0) shown in FIG. 2A. In addition, TMR sensors having a stacked structure with a second stacking pattern (n = 1, 2) shown in FIG. 8B were also produced.

After microfabrication processing was performed on the elements after film formation, a heat treatment was performed in a magnetic field at 300°C for 1 hour. FIG. 7 shows R-H characteristics. Here, the resistance value is standardized into the resistance change ratio. FIG. 7 shows characteristics of two samples different in thicknesses of an intermediate layer A (AgSn) and an intermediate layer B. Both samples exhibit even function R-H characteristics and a resistance change ratio of about 160%, but the value of the saturation magnetic field and the inclination (that is, sensitivity) of the resistance change ratio with respect to the magnetic field change are adjusted by difference thicknesses of the intermediate layer A and the intermediate layer B. The resistance change ratio is the same as that of a spin valve type TMR sensor produced under the same heat treatment conditions and is improved as compared with 110% of the single soft pin type TMR element of the related art shown in FIG. 18.

[Table 1]

| Configuration | Material | Thickness (nm) |
|---|---|---|
| Cap Layer | Ru | 8 |
| Antiferromagnetic Layer B | IrMn | 8 |
| Ferromagnetic Layer B2 | CoFe | 3 |
| Coupling Layer B | Ru | 0.8 |
| Ferromagnetic Layer B1 | CoFe | 3 |
| Intermediate Layer B | AgSn | 2 to 3.5 |

(continued)

| Configuration | Material | Thickness (nm) |
|---|---|---|
| Second Free Layer | CoFe | 1 |
| | CoFeBTa | 10 |
| | Ta | 0.3 |
| | CoFeB | 3 |
| Tunnel Barrier Layer | MgO | 1.8 |
| First Free Layer | CoFeB | 3 |
| | Ta | 0.3 |
| | CoFeBTa | 10 |
| | CoFe | 1 |
| Intermediate Layer A | AgSn | 2 to 3 |
| Ferromagnetic Layer A | CoFe | 2 |
| Antiferromagnetic Layer A | IrMn | 6 |
| Under layer | Ru | 2 |
| | Ta | 2 |
| Lower Electrode | Cu | 100 |
| Substrate | Si | |
| Conditions of Heat Treatment in Magnetic Field: 300°C, 1 h, 5 kOe | | |

<Magnetic Characteristic Evaluation Example 2: Control of Soft Pin Magnetic Field Control for Free Layer>

FIGS. 8A and 8B show that saturation magnetic fields and magnetic permeabilities of first free layers and second free layers of the stacked structure bodies of the first and second stacking patterns can be controlled by film thicknesses of the intermediate layer A and the intermediate layer B. First, FIG. 8A shows results of measurement of a magnetization curve of the first free layer of the stacked structure body having the first stacking pattern (n = 0). The magnetization curve was measured for each of samples different in film thickness of the intermediate layer A (AgSn is used). Here, the materials and the film thicknesses of the layers are the same as those in Table 1. The center of the hysteresis curve of the first free layer is shifted from a magnetic field zero, and the magnitude of the shift is a magnitude of the unidirectional magnetic anisotropy with respect to the first free layer and is referred here to as a soft pin magnetic field Hpin. By controlling the magnitude of Hpin, the operation magnetic field range of the TMR sensor can be controlled. In FIG. 8, the soft pin magnetic field Hpin is plotted with respect to the film thickness of the intermediate layer consisting of AgSn for various stacked structures. In any case, Hpin decreases with an increase in film thickness of the intermediate layer. From the data, it is possible to know the appropriate film thickness of the intermediate layer for obtaining desired Hpin. In addition, it is easily presumed that, by further reducing the film thickness of the AgSn intermediate layer to be less than 2.2 nm or 2.3 nm shown here, even larger Hpin can be obtained.

<Magnetic Characteristic Evaluation Example 3: Asymmetry of R-H characteristics (experiment)>

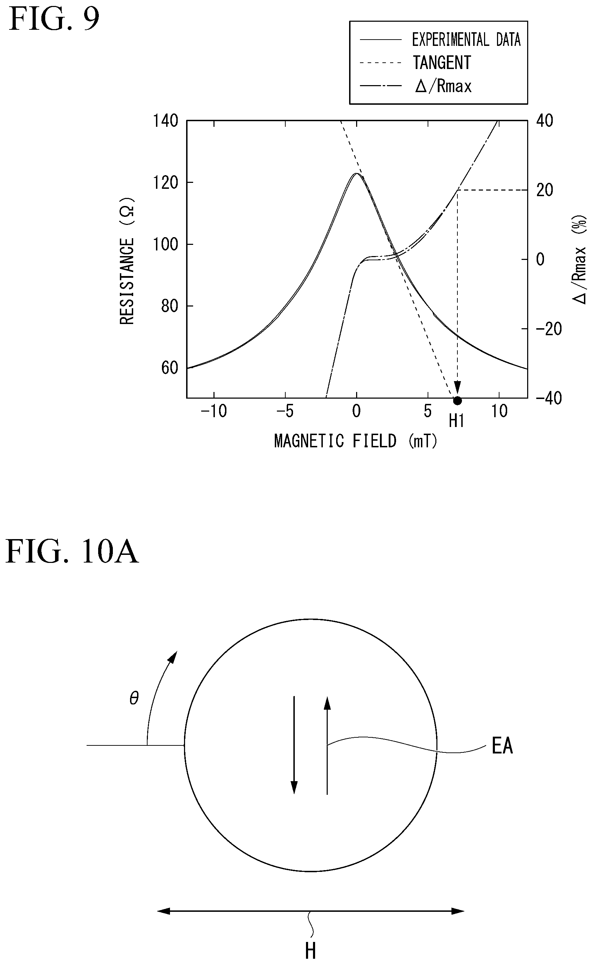

First, a magnetic field H1 is defined by the method shown in FIG. 9. This is because, in the R-H characteristics as in FIGS. 1, 7, and 9, it is difficult to define a magnetic field in which the value of the resistance R is constant, that is, the saturation magnetic field, and thus the magnetic field H1 is defined as a substitute for the saturation magnetic field. A magnetic field in which a standardized value ($\Delta$/Rmax) obtained by dividing the difference between experimental data of the R-H characteristics and a tangent drawn to the experimental data at a point where a differential dR/dH of the experimental data is maximized, by the maximum resistance value of the experimental data, is 20% is defined as the magnetic field H1. The magnetic field H1 for the experimental data is 7.0 mT.

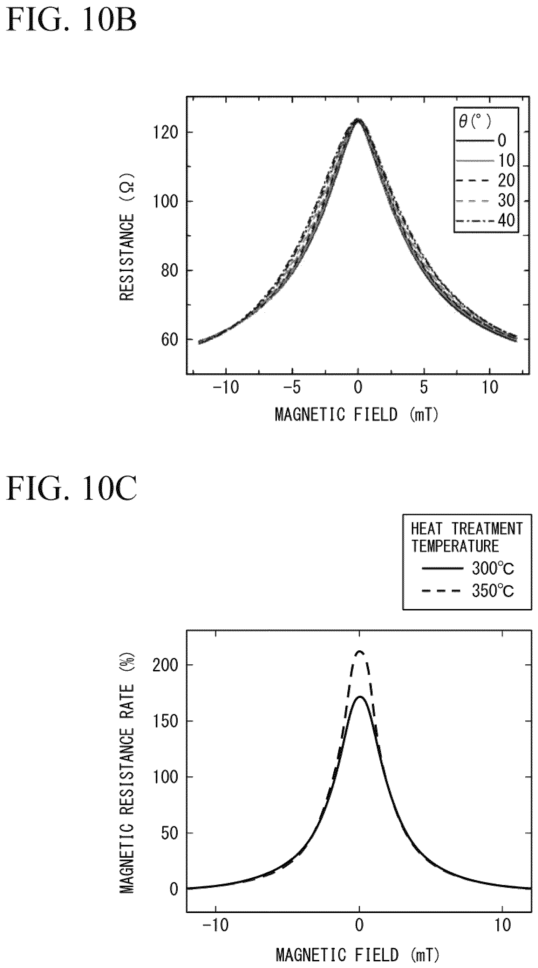

FIG. 10A shows a state in which an external magnetic field H is inclined by an angle of deviation $\theta$ relative to a magnetization hard axis (a direction orthogonal to an easy axis EA) of the free layer of the dual soft pin TMR sensor. FIG. 10B shows an R-H curve in a case where the external magnetic field is applied to the free layer of the dual soft pin TMR sensor in a state of being inclined by the angle of deviation $\theta$ shown in FIG. 10A. This means how much the output waveform of the sensor is distorted when the sensor is disposed to be shifted from an appropriate direction (the hard axis of the free layer) in mounting of the sensor as a position detection sensor and is directly related to an error in the position detection.

The asymmetry of the R-H curve was defined as follows. When the element resistance R is represented by R(H) as a function of the magnetic field H, the asymmetry of the R-H curve when H = H' (> 0) is defined by the following equation.

$$\mathrm{Asy(H') = [R(H') - R(-H')]/[(R(H') + R(-H')]\ (\%)}$$

Below, the asymmetry when H = H1, that is, the value of Asy(H1) (referred to as H1 asymmetry) is used.

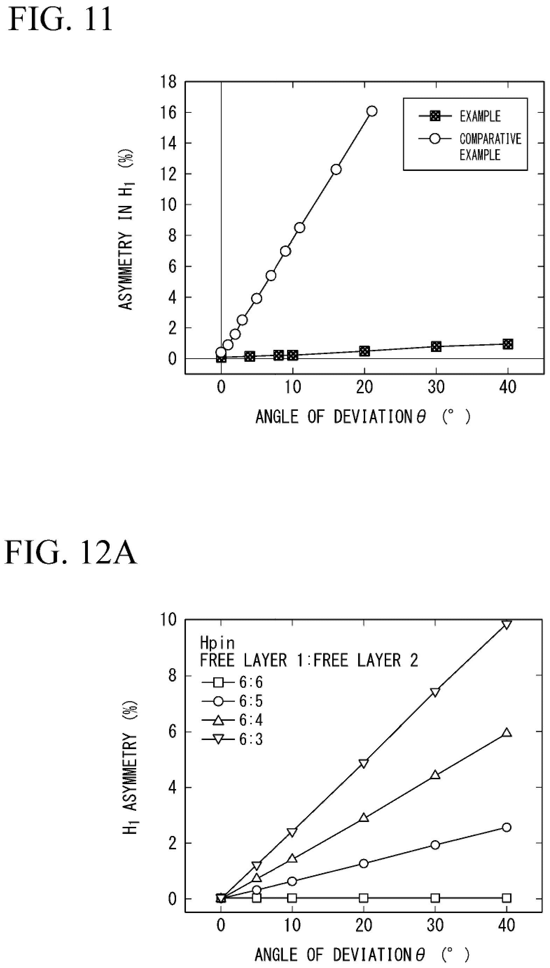

A dual soft pin TMR sensor of Table 1 was prepared as an example, and a single soft pin TMR sensor shown in Table 2 was prepared as a comparative example. FIG. 11 shows the dependence of the H1 asymmetry on the angle of deviation θ in the example and the comparative example. The stacked structure of the comparative example consists of under layer/antiferromagnetic A/ferromagnetic layer A/intermediate layer A/first free layer/tunnel barrier layer/ferromagnetic layer B2/coupling layer B/ferromagnetic layer B2/antiferromagnetic layer B/cap layer. In all of the comparative example and the example, the H1 asymmetry linearly increases with an increase in angle of deviation θ. However, in the example, the value of the asymmetry in the magnetic field H1 is smaller than that in the comparative example. The value of the asymmetry in H1 at θ = up to 20° in the example is about 1/30 of that in the comparative example.

[Table 2]

| Configuration | Material | Thickness (nm) |
|---|---|---|
| Cap Layer | Ru | 8 |
| Antiferromagnetic Layer | IrMn | 8 |
| Ferromagnetic Layer | CoFe | 3 |
| Coupling Layer | Ru | 0.8 |
| Reference Layer | CoFe | 1 |
| | CoFeB | 0.5 |
| | Ta | 0.3 |
| | CoFeB | 2.5 |
| Tunnel Barrier Layer | MgO | 1.8 |
| Free Layer 1 | CoFeB | 3 |
| | Ta | 0.3 |
| | CoFeBTa | 20 |
| | CoFe | 1 |
| Intermediate Layer | AgSn | 2.3 |
| Ferromagnetic Layer | CoFe | 2 |
| Antiferromagnetic Layer | IrMn | 6 |
| Under layer | Ru | 2 |
| | Ta | 2 |
| Lower Electrode Substrate | Cu | 100 |
| Si | | |
| Conditions of Heat Treatment in Magnetic Field: 350°C, 1 h, 5 kOe | | |

FIG. 10C is a diagram explaining the dependence of the resistance change ratio of a stacked structure body having the third stacking pattern according to the third embodiment on an annealing temperature. In a case where the annealing temperature for the sensor having the third stacking pattern is 300°C, the maximum resistance change ratio (dR/Rmin) is 170% when the external magnetic field is 0 mT. In a case where the annealing temperature is 350°C, the maximum resistance change ratio (dR/Rmin) reaches 210% when the external magnetic field is 0 mT. That is, the characteristics in which the maximum resistance change ratio (dR/Rmin) exceeds 200% when the external magnetic field is 0 mT are obtained at an annealing temperature of 335°C or higher and 360°C or lower.

<Magnetic Characteristic Evaluation Example 4: Asymmetry of R-H characteristics (simulation)>

The asymmetry of the R-H curve was simulated.

FIG. 12A shows the H1 asymmetry of the dual soft pin TMR sensor according to the present embodiment. The magnitude of Hpin of the first free layer is desirably the same as that of Hpin of the second free layer. In order to make the magnitudes of Hpin's of the first free layer and the second free layer the same, it is necessary to precisely control the film thickness of the intermediate layer or the dust layer. Here, the H1 asymmetry was calculated by changing a ratio between Hpin of the first free layer and Hpin of the second free layer from 6:6 to 6:3. In a case where the Hpin ratio is 6:6, that is, Hpin of the first free layer and Hpin of the second free layer are the same, the H1 asymmetry is zero with respect to any angle of deviation $\theta$. As the asymmetry of the magnitudes of Hpin's of the first free layer and the second free layer increases, the H1 asymmetry of the R-H curve increases. In addition, the H1 asymmetry linearly increases with respect to the angle of deviation $\theta$.

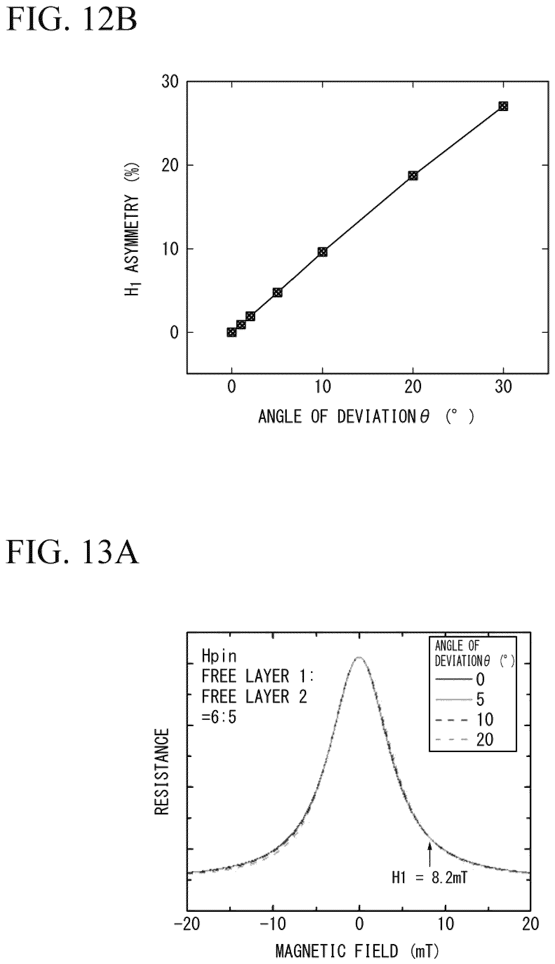

FIG. 12B shows the H1 asymmetry of the single soft pin TMR sensor that is the comparative example. The H1 asymmetry of the single soft pin TMR sensor linearly increases with respect to the angle of deviation $\theta$, but the magnitude thereof is much larger than that of the dual soft pin TMR sensor. For example, the H1 asymmetry of the single soft pin TMR sensor at $\theta = 10°$ is 9.6%, that is much larger than the H1 asymmetry of the dual pin TMR sensor of 0.6%, 1.4%, and 2.4% (corresponding to the Hpin ratios of 6:6, 6:5, and 6:3) at $\theta = 10°$. In reality, Hpin's of the first free layer and the second free layer can be sufficiently matched with a difference of about 6:5 or a more uniform value, and as seen from the experimental data of FIGS. 12A and 12B, the dual soft pin TMR sensor can suppress the H1 asymmetry at $\theta = 10°$ to 1% or less, and exhibits R-H characteristics with high symmetry of the resistance value with respect to the positive/negative sign of the external magnetic field (the application direction of the external magnetic field).

FIG. 13A shows calculation values of the R-H curve of the dual soft pin TMR sensor and FIG. 13B shows calculation values of the R-H curve of the single soft pin TMR sensor. FIG. 13A is the R-H curve of the dual soft pin TMR sensor, and FIG. 13B is the R-H curve of the single soft pin TMR sensor. In the dual soft pin TMR sensor, even in a case where the angle of deviation $\theta$ is not zero, when a magnetic field (saturation magnetic field) having a sufficiently larger value than H1 is applied, substantially the same resistance value is exhibited regardless of the positive/negative sign if the absolute value of the magnetic field is the same. In the single soft pin TMR sensor, in a case where the angle of deviation $\theta$ is not zero, different resistance values are exhibited depending on the positive/negative sign in the saturation magnetic field even if the absolute value of the magnetic field is the same. One of the features of the dual soft pin TMR sensor is that, regardless of the angle of deviation $\theta$, the element resistance is consistent regardless of the positive/negative sign if the absolute values of the saturation magnetic field are the same.

Based on the above description, in a case where the dual soft pin TMR sensor is used, it is possible to reduce the asymmetry of the R-H characteristics of the sensor as compared with the single soft pin TMR sensor of the related art, even in a case where a direction of the sensor deviates from the magnetic field to be measured when being mounted.

<Configuration of TMR Element Array>

FIG. 14A is a configuration perspective view showing an example in which a plurality of TMR elements 100 of a dual soft pin TMR sensor are connected in series. The TMR elements 100 shown in FIG. 14 are connected in series via upper electrodes E1 and lower electrodes E2. FIG. 14B is a configuration perspective view showing an example in which a plurality of TMR elements 100 of a dual soft pin TMR sensor are connected in parallel and in series via upper electrodes E1 and lower electrodes E2.

In a TMR element array, a plurality of the TMR elements 100 of the dual soft pin TMR sensor may be connected in series, in parallel, or in a combination thereof. Therefore, it is possible to disperse the bias voltage applied to each TMR element 100, and it is possible to reduce the problem that the resistance change ratio is lowered by a high bias voltage.

<Bridge Configuration>

In a case where the dual soft pin TMR element is used as a position detection sensor, a bridge circuit configuration of FIG. 15 may be used. FIG. 15 is a circuit diagram of an encoder having a bridge configuration according to the present embodiment. Each of elements 157a to 157d represents the dual soft pin TMR sensor shown in FIG. 1. Current flows flow in parallel to a line connecting the element 157a and the element 157b and a line connecting the element 157c and the element 157d from a current source 155 toward an earth 156. The encoder detects an intermediate potential 153 between the element 157a and the element 157b and an intermediate potential 154 between the element 157c and the element 157d as a sensor output.

Next, a magnetic linear encoder and a magnetic rotary encoder including the TMR element and the magnetic sensor according to the present embodiment will be described.

FIG. 20 is a configuration perspective view of a magnetic linear encoder to which a magnetic sensor 200 according to the present embodiment is applied. The magnetic linear encoder has a permanent magnet sheet in which N and S poles are alternately magnetized as a magnetic scale 201. A position on a surface of the magnetic scale 201 (permanent magnet sheet) is detected by the magnetic sensor 200.

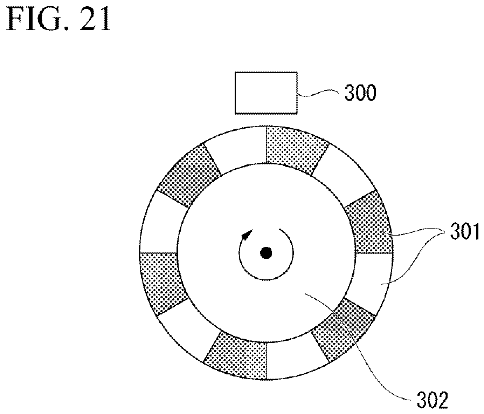

FIG. 21 is a configuration perspective view of a magnetic rotary encoder to which a magnetic sensor 300 according to the present embodiment is applied. In the magnetic rotary encoder, a permanent magnet region 301 in which N and S poles are alternately magnetized is provided on a peripheral surface of a rotor 302. The magnetic rotary encoder detects a rotation angle of the permanent magnet region 301 with the magnetic sensor 300.

Some embodiments of the present invention have been described above. However, these embodiments are presented as exemplary examples and are not intended to limit the scope of the present invention. These novel embodiments can be implemented in other various forms, and various omissions, replacements, and changes can be made without departing from the gist of the invention. The embodiments and modifications thereof are included in the scope and gist of the invention as well as in the scope of the invention described in the claims and its equivalents.

Industrial Applicability

According to a TMR element and a magnetic sensor including the TMR element of the present disclosure, the maximum resistance change ratio is as large as 210% in a case where the stacked structure is optimized, and the maximum resistance change ratio obtained by manufacturing within a typical range is as large as about 160%. Therefore, a TMR sensor capable of suppressing the asymmetry of R-H characteristics due to a deviation of the direction of a magnetic field to be detected can be obtained and is thus suitable for use in a device for position and rotation detection.

Reference Signs List

11: First free layer
12: Tunnel barrier layer
13: Second free layer
20, 30, 40, 50: Electrode
20a, 30a, 40a, 50a: Under layer
21, 31, 41, 51: Antiferromagnetic layer
22, 32, 42, 52: Ferromagnetic layer
23, 33: Intermediate layer
24, 34, 44, 54: First free layer
25, 35, 45, 55: Tunnel barrier layer
26, 36, 46, 56: Second free layer
27, 37: Intermediate layer
28, 38, 48, 58: Ferromagnetic layer
29, 39, 49, 59: Antiferromagnetic layer
22a, 28b, 32a, 32c, 38b, 38d, 53a, 53c, 58c: Ferromagnetic layer
22b, 28a, 32b, 32d, 38a, 38c, 53b, 53d, 57, 57c: Coupling layer
43, 47: Exchange coupling layer
53, 58a: Dust layer
160: Electrode
161: Under layer
162, 164, 167: Ferromagnetic layer
163, 165: Non-magnetic layer
166: repeated stacking

**Claims**

1. A magnetic junction comprising:

    a first free layer configured to have a magnetization easy axis and a magnetization hard axis orthogonal to the magnetization easy axis;

a tunnel barrier layer; and

a second free layer configured to have a magnetization easy axis and a magnetization hard axis orthogonal to the magnetization easy axis,

wherein the tunnel barrier layer is interposed between the first free layer and the second free layer,

the first free layer and the second free layer contain a ferromagnetic metal,

a detection-target magnetic field is configured to have a component to be applied in the magnetization hard axis direction of the first free layer and the second free layer,

the magnetization of the first free layer and the magnetization of the second free layer are stabilized in an antiparallel arrangement to each other in a state in which no external magnetic field is applied, and

the magnetization of the first free layer and the magnetization of the second free layer are arranged in parallel to each other in a state in which the strength of an external magnetic field applied in the magnetization hard axis direction of the first free layer and the second free layer reaches that of the saturation magnetic field of the first free layer and the second free layer.

2. The magnetic junction according to Claim 1,

wherein, until the external magnetic field applied in the magnetization hard axis direction of the first free layer and the second free layer reaches the saturation magnetic field, the magnetization of the first free layer and the magnetization of the second free layer rotate symmetrically with respect to a direction in which the external magnetic field is applied,

the angle formed between the magnetization of the first free layer and the magnetization of the second free layer is reduced with an increase in strength of the external magnetic field, and

as resistance magnetic field characteristics, even function characteristics symmetrical to positive/negative of the direction in which the external magnetic field is applied are exhibited.

3. The magnetic junction according to Claim 1,

wherein the tunnel barrier layer has at least one selected from the group consisting of $MgO$, $Mg\text{-}Al\text{-}O$, and $Al_2O_3$, and

the first free layer and the second free layer have at least a layer consisting of CoFeB.

4. The magnetic junction according to Claim 3,

wherein at least one of the first free layer and the second free layer is a stacked body including a plurality of layers,

the stacked body has the layer consisting of CoFeB, a layer consisting of CoFe, and a central layer,

the layer consisting of CoFe is at a position further away from the tunnel barrier layer than the layer consisting of CoFeB, and

the central layer is between the layer consisting of CoFeB and the layer consisting of CoFe, and includes any one selected from the group consisting of NiFe, CoFeSiB, and CoFeBTa.

5. A TMR element comprising:

the magnetic junction according to Claim 1,

wherein the magnetic junction has

a stacked structure body represented by

[ferromagnetic layer $A_i$/coupling layer $A_i]_n$/ferromagnetic layer $A_{n+1}$/intermediate layer A/the first free layer/the tunnel barrier layer/the second free layer/intermediate layer B/[ferromagnetic layer $B_j$/coupling layer $B_j]_{n+1}$/ferromagnetic layer $B_{n+2}$/ or

[ferromagnetic layer $A_j$/coupling layer $A_j]_{n+1}$/ferromagnetic layer $A_{n+2}$/intermediate layer A/the first free layer/the tunnel barrier layer/the second free layer/intermediate layer B/[ferromagnetic layer $B_i$/coupling layer $B_i]_n$/ferromagnetic layer $B_{n+1}$/,

here, n is an integer of 0 or more, when $n \neq 0$, i = 1, ..., n and j = 1, ..., n+1, the notation of [ferromagnetic layer $A_j$/coupling layer $A_j]_{n+1}$ means that a two-layer structure consisting of "ferromagnetic layer $A_j$/coupling layer $A_j$" is repeatedly stacked n+1 times, and the notation of [ferromagnetic layer $B_i$/coupling layer $B_i]_n$ means that a two-layer structure consisting of "ferromagnetic layer $B_i$/coupling layer $B_i$" is repeatedly stacked n times.

6. The TMR element according to Claim 5,

wherein the ferromagnetic layer $A_i$, the ferromagnetic layer $A_{n+1}$, the ferromagnetic layer $B_j$, the ferromagnetic layer $B_{n+2}$, the ferromagnetic layer $A_j$, and the ferromagnetic layer $B_i$ are CoFe,

the coupling layer $A_i$, the coupling layer $B_j$, the coupling layer $A_j$, and the coupling layer $B_i$ are Ru,

the intermediate layer A and the intermediate layer B have at least one selected from the group consisting of Cu, Ag, Cr, Ru, and AgSn,

the tunnel barrier layer has any one or more selected from the group consisting of MgO, Mg-Al-O, and $Al_2O_3$, and

the first free layer and the second free layer have at least a layer consisting of CoFeB.

7. A TMR element comprising:

the magnetic junction according to Claim 1,
wherein the magnetic junction has
a stacked structure body represented by
first antiferromagnetic layer/first ferromagnetic layer/first exchange coupling layer/the first free layer/the tunnel barrier layer/the second free layer/second exchange coupling layer/second ferromagnetic layer/second antiferromagnetic layer/,
the first exchange coupling layer and the second exchange coupling layer are Ru or Cr, and
one of magnetic coupling between the first ferromagnetic layer and the first free layer and magnetic coupling between the second ferromagnetic layer and the second free layer is antiferromagnetic coupling, and the other is ferromagnetic coupling.

8. The TMR element according to Claim 7,

wherein the first antiferromagnetic layer and the second antiferromagnetic layer are at least one of IrMn, PtMn, FeMn, and NiMn,
the first ferromagnetic layer and the second ferromagnetic layer are CoFe,
the first exchange coupling layer and the second exchange coupling layer are Ru,
the tunnel barrier layer includes any one selected from the group consisting of MgO, Mg-Al-O, and $Al_2O_3$, and
the first free layer and the second free layer have at least a layer consisting of CoFeB.

9. A TMR element comprising:

the magnetic junction according to Claim 1,
wherein the magnetic junction has
a stacked structure body represented by
antiferromagnetic layer A/dust layer A/[ferromagnetic layer $A_i$/coupling layer $A_i$]$_n$/the first free layer/the tunnel barrier layer/the second free layer/[coupling layer $B_j$/ferromagnetic layer $B_j$]$_{n+1}$/dust layer B/antiferromagnetic layer B/ or
antiferromagnetic layer A/dust layer A/[ferromagnetic layer $A_j$/coupling layer $A_j$]$_{n+1}$/the first free layer/the tunnel barrier layer/the second free layer/[coupling layer $B_i$/ferromagnetic layer $B_i$]$_n$/dust layer B/antiferromagnetic layer B/,
here, n is an integer of 0 or more, when n $\neq$ 0, i = 1, ..., n and j = 1, ..., n+1, the notation of [ferromagnetic layer $A_j$/coupling layer $A_j$]$_{n+1}$ means that a two-layer structure consisting of "ferromagnetic layer $A_j$/coupling layer $A_j$" is repeatedly stacked n+1 times, and the notation of [coupling layer $B_i$/ferromagnetic layer $B_i$]$_n$ means that a two-layer structure consisting of "coupling layer $B_i$/ferromagnetic layer $B_i$" is repeatedly stacked n times.

10. The TMR element according to Claim 9,

wherein the antiferromagnetic layer A and the antiferromagnetic layer B have at least one selected from the group consisting of IrMn, PtMn, FeMn, and NiMn,
the ferromagnetic layer $A_i$, the ferromagnetic layer $B_j$, the ferromagnetic layer $A_j$, and the ferromagnetic layer $B_i$ are CoFe,
the coupling layer $A_i$, the coupling layer $B_j$, the coupling layer $A_j$, and the coupling layer $B_i$ are Ru,
the dust layer A and the dust layer B are Ru having a thickness of 1 nm or less,
the tunnel barrier layer has at least one selected from the group consisting of MgO, Mg-Al-O, and $Al_2O_3$, and
the first free layer and the second free layer have at least a layer consisting of CoFeB.

11. The TMR element according to Claim 5,

wherein, in a state in which the detection-target magnetic field is zero, a maximum resistance is exhibited, and the magnetization of the first free layer and the magnetization of the second free layer are arranged in an antiparallel manner, and

by application of the detection-target magnetic field, the resistance is reduced, both of the magnetizations of the first free layer and the second free layer rotate by application of the detection-target magnetic field, and the angle formed between the magnetization of the first free layer and the magnetization of the second free layer is reduced with an increase in strength of the detection-target magnetic field.

12. The TMR element according to Claim 11,

wherein, when a direction in which the detection-target magnetic field is applied is inclined by 10° from a direction in the magnetization hard axis direction of the first free layer and the second free layer, magnetic field asymmetry of the resistance value with respect to positive/negative of a direction in which a magnetic field H1 is applied is within 1%,

here, the magnetic field H1 is the magnetic field in which a standardized value obtained by dividing the difference between a curve based on experimental data of resistance magnetic field (R-H) characteristics and a tangent determined with respect to the curve based on the experimental data at a point where the differential (dR/dH) of the curve based on the experimental data is maximized, by the maximum resistance value of the experimental data, is 20%, and

for the magnetic field asymmetry, when the element resistance R is represented by R(H) as a function of a magnetic field H, asymmetry of an R-H curve when H = H' (> 0) is defined by

$$\mathrm{Asy(H') = [R(H') - R(-H')]/[(R(H') + R(-H')]\ (\%)}$$

to define asymmetry of the resistance with respect to the magnetic field H1.

13. The TMR element according to Claim 5,
wherein the stacked structure body is positioned between a first structure consisting of substrate/lower electrode/under layer/antiferromagnetic layer and a second structure consisting of antiferromagnetic layer/cap layer.

14. The TMR element according to Claim 7,
wherein the stacked structure body is positioned between a third structure consisting of substrate/lower electrode/under layer and a fourth structure consisting of a cap layer.

15. The TMR element according to Claim 13,

wherein the substrate is a silicon wafer, or a ceramic wafer consisting of AlTiC or an aluminum oxide,
the under layer has a stacked configuration consisting of Ta and Ru,
the antiferromagnetic layer is any one selected from the group consisting of IrMn, PtMn, FeMn, and NiMn, and
the cap layer is Ru.

16. A TMR element array comprising:
a plurality of the TMR elements according to Claim 5, configured to be connected in at least one of series and parallel.

17. A magnetic sensor comprising:
a bridge circuit configured to use four TMR elements according to Claim 5.

18. A magnetic sensor comprising:
the TMR element array according to Claim 16, configured to be provided by bridge circuit connection.

19. A magnetic sensor for a linear encoder, comprising:
the TMR element according to Claim 5.

20. A magnetic rotary encoder comprising:
the TMR element according to Claim 5.

FIG. 1

EP 4 571 268 A1

# FIG. 2A

| | |
|---|---|
| | 29 |
| → | 28b |
| | 28a |
| ← | 28 |
| | 27 |
| ← | 26 |
| | 25 |
| → | 24 |
| | 23 |
| → | 22 |
| | 21 |
| | 20a |
| | 20 |

# FIG. 2B

# FIG. 2C

FIG. 3A

# FIG. 3B

# FIG. 3C

# FIG. 4

FIG. 5A

FIG. 5B

# FIG. 5C

# FIG. 6

# FIG. 7

## FIG. 8A

(a)

FILM THICKNESS OF AgSn
INTERMEDIATE LAYER (nm)
——— 2.2
- - - 2.5
——— 2.8

MAGNETIC MOMENT (ARBITRARY UNIT)

MAGNETIC FIELD (mT)

## FIG. 8B

—▨— FIRST FREE LAYER HAVING FIRST STACKING PATTERN (n = 0)
—●— FIRST FREE LAYER HAVING SECOND STACKING PATTERN (n = 1)
—▲— FIRST FREE LAYER HAVING SECOND STACKING PATTERN (n = 2)
- -□- - SECOND FREE LAYER HAVING SECOND STACKING PATTERN (n = 0)
- -○- - SECOND FREE LAYER HAVING FIRST STACKING PATTERN (n = 0)

(b)

SOFT PIN MAGNETIC FIELD Hpin OF FREE LAYER (mT)

FILM THICKNESS OF AgSn INTERMEDIATE LAYER (nm)

FIG. 9

FIG. 10A

## FIG. 10B

## FIG. 10C

## FIG. 11

## FIG. 12A

# FIG. 12B

# FIG. 13A

FIG. 13B

FIG. 14A

FIG. 14B

FIG. 15

## FIG. 16A

# FIG. 16B

FIG. 17

（B）

173
172
171
170

（D）

R

（C）

173
172
171
170

H

（A）

173
172
171
170

FIG. 18

（B）

183
182
181

（D）

40

30

20

−10    −5     0     5     10

H（mT）

（C）

183
182
181

（A）

183
182
181

EP 4 571 268 A1

## FIG. 19

## FIG. 20

FIG. 21

# EP 4 571 268 A1

## INTERNATIONAL SEARCH REPORT

International application No.

**PCT/JP2023/017513**

### A. CLASSIFICATION OF SUBJECT MATTER

*G01D 5/245*(2006.01)i; *G01R 33/02*(2006.01)i; *G01R 33/09*(2006.01)i; *H10N 50/10*(2023.01)i
FI: H10N50/10 Z; G01R33/09; G01R33/02 Q; G01D5/245 R; H10N50/10 U

According to International Patent Classification (IPC) or to both national classification and IPC

### B. FIELDS SEARCHED

Minimum documentation searched (classification system followed by classification symbols)

G01D5/245; G01R33/02; G01R33/09; H10N50/10

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2012-049213 A (MITSUBISHI ELECTRIC CORP) 08 March 2012 (2012-03-08) paragraphs [0030]-[0060], fig. 3, 4 | 1-3 |
| A | | 4-20 |
| A | JP 2009-289390 A (TDK CORP) 10 December 2009 (2009-12-10) paragraphs [0031]-[0150], fig. 1-17 | 1-20 |
| A | JP 2013-070054 A (SEAGATE TECHNOLOGY LLC) 18 April 2013 (2013-04-18) paragraphs [0007]-[0036], fig. 1-9 | 1-20 |
| A | JP 2010-092579 A (HEADWAY TECHNOLOGIES INC) 22 April 2010 (2010-04-22) paragraphs [0020]-[0043], fig. 1-6 | 1-20 |

☐ Further documents are listed in the continuation of Box C.   ☑ See patent family annex.

| | | |
|---|---|---|
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **26 July 2023** | **08 August 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

44

**INTERNATIONAL SEARCH REPORT**
Information on patent family members

International application No.

**PCT/JP2023/017513**

| Patent document cited in search report | | | Publication date (day/month/year) | Patent family member(s) | | | Publication date (day/month/year) |
|---|---|---|---|---|---|---|---|
| JP | 2012-049213 | A | 08 March 2012 | (Family: none) | | | |
| JP | 2009-289390 | A | 10 December 2009 | US paragraphs [0056]-[0167], fig. 1-17 | 2009/0296283 | A1 | |
| JP | 2013-070054 | A | 18 April 2013 | US paragraphs [0011]-[0042], fig. 1-9 | 2013/0071691 | A1 | |
| | | | | CN | 103021423 | A | |
| | | | | KR | 10-2013-0031806 | A | |
| JP | 2010-092579 | A | 22 April 2010 | US paragraphs [0036]-[0053], fig. 1-6 | 2010/0085666 | A1 | |

**REFERENCES CITED IN THE DESCRIPTION**

**Patent documents cited in the description**

- JP 2022127029 A
- JP 2021071334 A
- US 20170154643 A1

**Non-patent literature cited in the description**

- *Journal of Applied Physics*, 2002, vol. 92, 4722
- *J. Appl. Phys.*, 2012, vol. 111, 07C710
- *The 45th Annual Conference of the Magnetics Society of Japan*, 01aB-11
- *Journal of the Japan Institute of Metals and Materials*, 2011, vol. 75, 419-423
- *Journal of the Japan Institute of Metals and Materials*, 2012, vol. 76, 375-379